# EUROPEAN PATENT SPECIFICATION

(11) **EP 3 108 497 B1**
(45) Date of publication and mention of the grant of the patent: **11.11.2026**
(21) Application number: 15773817.0
(22) Date of filing: 02.04.2015
(51) Int. Cl.: H10B 20/25, H10W 20/49, G11C 17/16, H10D 84/01, H10D 84/03

(54) **ANTI-FUSE MEMORY CELL**
ANTIFUSE SPEICHERZELLE
CELLULE DE MÉMOIRE ANTI-FUSIBLE

(30) Priority: 03.04.2014 US 201414244499
(43) Date of publication of application: 28.12.2016
(73) Proprietor: Synopsys, Inc., Mountain View, CA 94043 (US)
(72) Inventor: KURJANOWICZ, Wlodek, Arnprior, Ontario K7S 3T2 (CA)
(74) Representative: AWA Sweden AB
(86) International application number: PCT/CA2015/050266
(87) International publication number: WO 2015/149182

(56) References cited:
- WO-A1-2013/132766
- CA-A1- 2 646 367
- CA-A1- 2 682 092
- CA-A1- 2 815 989
- CA-A1- 2 816 237
- US-A1- 2005 130 441
- US-A1- 2009 250 726
- US-A1- 2011 042 735
- US-A1- 2015 024 564
- MASSOUD H Z ET AL: "THERMAL OXIDATION OF SILICON IN DRY OXYGEN: GROWTH-RATE ENHANCEMENT IN THE THIN REGIME II. PHYSICAL MECHANISMS", JOURNAL OF THE ELECTROCHEMICAL SOCIETY, ELECTROCHEMICAL SOCIETY, INC, US, vol. 132, no. 11, 1 November 1985 (1985-11-01), pages 2693 - 2700, XP008043141, ISSN: 0013-4651

## Description

### FIELD OF THE INVENTION

The present invention relates generally to non-volatile memory. More specifically, the invention is directed to anti-fuse memory cell structures.

### BACKGROUND OF THE INVENTION

Over the past 30 years, anti-fuse technology has attracted significant attention of many inventors, IC designers and manufacturers. An anti-fuse is a structure alterable to a conductive state, or in other words, an electronic device that changes state from not conducting to conducting. Equivalently, the binary states can be either one of high resistance and low resistance in response to electric stress, such as a programming voltage or current. There have been many attempts to develop and apply anti-fuses in microelectronic industry, but the most successful anti-fuse applications to date can be seen in FGPA devices manufactured by Actel and Quicklogic, and redundancy or option programming used in DRAM devices by Micron.

A summary of the progression of anti-fuse development follows as evidenced by issued United States patents.

Anti-fuse technology development started with U.S. Patent No. 3,423,646, which disclosed a thin film formable diode PROM built as an array of horizontal and vertical conductors with a thin dielectric (aluminium oxide) between the conductors, at their crossings. Such NVM memory was programmed through perforation of the dielectric in some of the crossings. A formable diode would act as an open circuit until a voltage of sufficient magnitude and duration is applied to the crossing to cause forming of the aluminum oxide intermediate layer at which time device would act as a tunnelling diode.

U.S. Patent No. 3,634,929 disclosed an inter-metal semiconductor anti-fuse array, the structure of the anti-fuse consisting of a thin dielectric capacitor (AlO2, SiO2 or Si3N4) utilizing two (Al) conductors located above and connected to the semiconductor diode.

A programmable dielectric ROM memory structure using a MOS capacitor and a MOS switching element was shown in U.S. Patent No. 4,322,822 (McPherson). This cell was formed as a standard gate-oxide-over-substrate capacitor having a gate connected to a MOS transistor using a buried contact. In order to lower the oxide breakdown voltage, which needed to be smaller for the anti-fuse capacitor then for the MOS switch, a V-shaped grove in the capacitor area was proposed. Since the capacitor was formed between the poly gate and the grounded p-type substrate, the rupture voltage had to be applied to the capacitor through an access transistor. The Gate/Drain and Gate/Source edges of the access transistors were located at the second field oxide, much thicker then the gate oxide in the channel area, which greatly improved Gate/S-D breakdown voltage.

U.S. Patent No. 4,507,757 (McElroy) proposed a method for lowering gate oxide breakdown voltage through avalanche junction breakdown. Although the original McElroy ideas evolved around using gated diodes to locally induce avalanche breakdown, which in turn lowered dielectric rupture voltage by enhanced electron tunnelling, he actually introduced or embodied other and perhaps more important elements to anti-fuse technology: (a) Dual gate oxide anti-fuse: access transistor gate oxide thicker then anti-fuse dielectric. McElroy's dual gate oxide process steps are: initial gate oxidation, etching areas for thinner gate oxide and subsequent gate oxidation. This procedure is now used in standard CMOS technologies for "I/O" and "1T" devices. (b) A "common-gate" (planar DRAM like) anti-fuse connection where access transistor connects to anti-fuse diffusion (Drain) node and all the anti-fuse gates are connected together. This is opposite to McPherson arrangement and results in much denser cell since the buried contact is eliminated. (c) Limiting resistor between common anti-fuse gate and external ground. (d) Two-terminal anti-fuse MOS device (a half transistor): McElroy concluded that only two terminals are needed in anti-fuse capacitor: D and G. The Source is not really needed for anti-fuse programming or operation and can be fully isolated from the active area. The bulk connection does not play any role either except for the avalanche breakdown. So the source role is limited to collecting carriers from the avalanche breakdown should the local substrate potential increase to forward bias the emitter of a parasitic n-p-n device formed by D, B and S.

It wasn't until 1985 when U.S. Patent No. 4,543,594 (Mohsen) proposed an anti-fuse design suitable for redundancy repair. As such application requires much lower density than PROM, it was easier to supply external high voltage necessary to rupture the oxide without actually passing this voltage through the access transistors. Mohsen's anti-fuse structure consisted of a thin oxide (50-150A SiO2) polysilicon capacitor over a doped region. He believed that silicon from the substrate or silicon from the electrode where a polysilicon electrode is used melts into pin holes in the insulative layer to provide the conductor, and his test data showed that where the oxide layer is approximately 100A thick and has an area between 10 to 500 um², fusion occurred at a voltage of 12 to 16 volts. The current required to cause this fusion is less than 0.1 uA/um2 of capacitor area, and the resulting fused link has a resistance of approximately 0.5 to 2K ohms. A link, once fused, can handle currents of up to 100 milliamps at room temperature for approximately one second before it heals to an open fuse. Taking into account electron migration wear-out, the predicted wear-out lifetime of a link, once fused, is substantially greater than 3E8 hours.

The possibility of anti-fuse self-healing under current stress appeared to be the main roadblock for application of this technology in such areas like PROMs, PLDs and FPGAs, where constant fuse stress was required. The anti-fuse healing problem was resolved later by Mohsen and others at Actel in U.S. Patent No. 4,823,181. Actel teaches the way to implement a reliable programmable low impedance anti-fuse element by using an ONO structure instead of silicon dioxide. Actel's method required an ohmic contact after dielectric rupture. This was achieved either by using heavily doped diffusion, or by putting an ONO dielectric between two metal electrodes (or silicide layers). The necessity of an Arsenic doped bottom diffusion electrode was revised later in U.S. Patent No. 4,899,205, where it was allowed for either top-poly or bottom-diffusion to be highly doped.

U.S. Patent No. 5,019,878 taught that if the drain is silicided, the application of a programming voltage in the range of ten to fifteen volts from the drain to the source reliably forms a melt filament across the channel region. A gate voltage may be applied to control the specific transistors to melt. IBM discovered similar effect by proposing a channel anti-fuse in U.S. Patent No. 5,672,994. They discovered that with 0.5um technology, the BVDSS for the nmos transistor is not only in the order of 6.5V, but once the S-D punch through occurs it creates permanent damage resulting in few kilo ohms leakage between the source and the drain.

U.S. Patent Nos. 5,241,496 and 5,110,754 to Micron, disclosed a DRAM cell based anti-fuse (trench and stack). In 1996, Micron introduced a well-to-gate capacitor as an anti-fuse in U.S. Patent No. 5,742,555. U.S. Patent No. 6,087,707 proposed an N-Well coupled anti-fuse as a way to eliminate undercut defects associated with polysilicon etching. U.S. Patent Application No. 2002/0027,822 proposed a similar anti-fuse structure, but with n+ regions removed to create an asymmetrical ("unbalanced") high voltage access transistor using the N-well as a drain electrode.

U.S. Patent No. 6,515,344 proposed a range of P+/N+ anti-fuse configurations, implemented using a minimum size gate between two opposite type diffusion regions.

U.S. Patent No. proposed an nmos anti-fuse built in an isolated P-well using a standard Deep N-Well process. Another variant of Deep N-Well based anti-fuses is disclosed in U.S. Patent No. 6,611,040.

U.S. Patent Application Nos. 2002,0074,616 and 2004,0023,440 disclose other Deep N-Well anti-fuses. These anti-fuses consisted of a capacitor featuring direct tunnelling current rather then Fowler Nordheim current. These applications confirm that anti-fuse performance is generally improved for thinner gate oxide capacitors (approx 20A, which is typical for transistors in 0.13um process).

U.S. Patent No. 6,580,145 disclosed a new version of a traditional anti-fuse structure utilizing dual gate oxides, with the thicker gate oxide being used for nmos (or pmos) access transistors and the thinner gate oxide for the capacitor. The N-Well (or P-Well) is used as a bottom plate of the anti-fuse capacitor.

The idea of creating a source drain short through the gate by separately breaking the S-G and D-G dielectric regions of the transistor is disclosed in U.S. Patent No. 6,597,234.

U.S. Patent Publication No. 20040004269 disclosed an anti-fuse built from a MOS transistor having gate connected to the gate of a capacitor, degenerated by a thinner gate oxide and heavy doping under the channel through additional implantation (a diode). The rupture voltage is applied to a bottom plate of the capacitor.

In U.S. Patent No. 6,667,902 (Peng) Peng attempts to improve a classic planar DRAM-like anti-fuse array by introducing "row program lines" which connect to the capacitors and run parallel to the word lines. If decoded, the row program lines can minimize exposure of access transistors to a high programming voltage, which would otherwise occur through already programmed cells. Peng and Fong further improve their array in U.S. Patent No. 6,671,040 by adding a variable voltage controlling programming current, which allegedly controls the degree of gate oxide breakdown, allowing for multilevel or analog storage applications.

Most recently, U.S. Patent Application No. 2003/0202376 (Peng) shows a memory array using a single transistor structure. In the proposed memory cell, Peng eliminates the LDD diffusion from a regular NMOS transistor. A cross-point array structure is formed of horizontal active area (S/D) stripes crossing vertical poly gate stripes. Drain contacts are shared between neighbouring cells and connected to horizontal wordlines. Source regions are also shared and left floating. Peng assumes that if the LDD diffusion is omitted, the gate oxide breakdown location will be far enough from the drain area and a local N+ region will be created rather than D-G (drain-gate) short. If such a region was created, the programmed cells could be detected by positively biasing the gate and sensing the gate to drain current. In order to reduce the G-D or S-D (source-drain) short probability, Peng proposes increasing gate oxide thickness at the G-D and S_D edges through modification of a gate sidewall oxidation process. Peng's array requires that both source and drain regions be present in the memory cells, row wordlines coupled to transistor drain regions, and the column bitlines formed from transistor gates. Such an unusual connection must be very specific to Peng's programming and reading method, requiring a decoded high voltage (8V in 1.8V process) applied to all drain lines except for the one to be programmed. The decoded high voltage (8V) is applied to the gates of the column to be programmed, while the other gates are kept at 3.3V.

Although Peng achieves a cross-point memory architecture, his array requires CMOS process modifications (LDD elimination, thicker gate oxide at the edge) and has the following disadvantages: (a) All row decoders, column decoders and sense amplifiers must switch a wide range of voltages: 8V/3.3V/0V or 8V/1.8V/0V. (b) During a program operation, the 3.3V column drivers are effectively shorted to 8V row drivers or 0V drivers through programmed cells. This puts many limits on the array size, affects driver size and impacts reliability and effectiveness of programming. (c) Every program operation requires that all the array active areas (except for the programmed row) are biased at 8V. This leads to large N++ junction leakage current, and again limits array size. (d) The gate oxide breaking spot is assumed to be located far enough from the drain area so the punch through is not happening at 8V bias. At the same time, the transistor must operate correctly at 1.8V biasing - connecting to the channel area. This is not achievable without significant process modification. (e) Peng assumes that the gate oxide will not break on the source or drain edge if the LDD is not present. It is however known in the art that the S/D edges are the most likely locations for the oxide breakdown because of defects and electric field concentration around sharp edges.

Peng attempts to solve some of the high voltage switching problems in U.S. Patent Application No. 2003/0206467. The high blocking voltage on wordlines and bitlines is now replaced with "floating" wordlines and bitlines, and restrictions on the distance from the channel to the source and drain regions has been changed. Although floating wordlines and bitlines may ease problems with high voltage switching, they do not solve any of the above mentioned fundamental problems. Additionally they introduce severe coupling problems between the switched and the floating lines.

U.S. Patent Application Publication No. 20060292755 (Parris) introduces a well-to-gate capacitor as an anti-fuse element having a tunable, variable gate oxide thickness formed through a thermal oxide process, in an attempt to increase reliability in programming of the anti-fuse element, by localizing the area of oxide breakdown (or rupture). The state of the Parris anti-fuse capacitor is detected by sensing a current in the well, that flows from its top plate through a programmed conductive link in the oxide breakdown region, and into the well which acts as the bottom plate. Hence the Parris anti-fuse capacitor does not function as a transistor since it does not have "channel" region. Because of the well sensing scheme, Parris teaches that each anti-fuse capacitor is formed in an isolated well, while the corresponding access transistors are formed outside of the well. Such a design would not be suited for high density applications since the access transistors must be spaced from the well according to minimum design rule requirements. Thus the Parris memory array has low area efficiency.
U.S. Patent Application Publication No. 2005/0130441 (Park) discloses a semiconductor device comprising a semiconductor substrate, a gate formed on the semiconductor substrate, a gate oxide layer interposed between the semiconductor substrate and the gate, and source and drain regions formed within the substrate at opposite sides of the gate. The gate oxide layer has a first region with a first thickness and a second region with a second thickness, and an intermediate region with an angled gate oxide between the first region and the second region. The second thickness is larger than the first thickness.
U.S. Patent Application Publication No. 2009/0250726 A1 (Kurjanowicz) discloses an anti-fuse based OTP memory cell and its manufacturing method. The gate oxide under the anti-fuse has a first region with a first thickness and a second region with a second thickness, the second thickness being larger than the first thickness. The gate oxide is formed by thermal oxidation. The OTP cell further comprises an access transistor.

Today, anti-fuse developments concentrate around 3-dimensional thin film structures and special inter-metal materials. All these anti-fuse technologies require additional processing steps not available in standard CMOS process, prohibiting anti-fuse applications in typical VLSI and ASIC designs, where programmability could help overcome problems with ever shrinking device life cycles and constantly rising chip development costs. Therefore there is an apparent need in the industry for a reliable anti-fuse structures utilizing standard CMOS process.

All the prior art anti-fuse cells and arrays either require special processing steps or suffer from high voltage exposure of MOS switching elements, leading to manufacturability and reliability problems. They are also limited to low density memory applications, with the exception of Peng's single transistor cell, which in turn has very doubtful manufacturability.

It is, therefore, desirable to provide a simple and reliable, high density, anti-fuse array architecture suitable for implementation in standard CMOS technology, without any additional processing steps.

### SUMMARY OF THE INVENTION

It is an object of the present invention to obviate or mitigate at least one disadvantage of the previous anti-fuse arrays by providing an anti-fuse memory cell having high reliability by minimizing a thin gate oxide area of a variable thickness gate oxide formed between a polysilicon gate and the active area of the substrate.

In a first aspect, there is provided a method of forming a variable thickness gate oxide for an anti-fuse transistor as defined by claim 1.

In yet another embodiment of the first aspect, thermally growing includes growing the second oxide in the thin oxide area at a first rate and growing the second oxide in the thick gate oxide area at a second rate less than the first rate. In this embodiment, growing the second oxide in the thin oxide area at a first rate includes consuming a substrate surface of the thin oxide area to a first depth, and growing the second oxide in the thick gate oxide area includes consuming a substrate surface of the thick gate oxide area to a second depth less than the first depth. Thermally growing can further include forming an angled oxide area between the thick gate oxide area and the thin gate oxide area, where the angled oxide area has a thickness different from the combination of the first oxide and the second oxide in the thick gate oxide area, and from the second oxide in the thin oxide area. In this embodiment, the method further includes forming a common gate over the first oxide the second oxide, and the angled oxide area.

Other aspects and features of the present invention will become apparent to those ordinarily skilled in the art upon review of the following description of specific embodiments of the invention in conjunction with the accompanying figures.

### BRIEF DESCRIPTION OF THE DRAWINGS

Embodiments of the present invention will now be described, by way of example only, with reference to the attached Figures, wherein:
Fig. 1 is a circuit diagram of a DRAM-type anti-fuse cell;
Fig. 2 is a planar layout of the DRAM-type anti-fuse cell of Figure 1;
Fig. 3 is a cross-sectional view of the DRAM-type anti-fuse cell of Figure 2 along line x-x;
Fig. 4 is a cross-sectional view of an anti-fuse transistor not according to the present invention;
Fig. 5A is a planar layout of the anti-fuse transistor of Figure 4;
Fig. 5B is a planar layout of the anti-fuse transistor of Figure 4 showing an alternate OD2 mask configuration;
Fig. 6 is a flow chart of a method for forming a variable thickness gate oxide
Fig. 7A-7C illustrate the formation of the variable thickness gate oxide in accordance with steps of the flow chart of Figure 6;
Fig. 8A-8C illustrate a formation method of the variable thickness gate oxide according to the claimed invention;
Fig. 9 is a magnified illustration of the variable thickness gate oxide shown in Figure 8C;
Fig. 10 is a cross sectional view of an anti-fuse transistor memory cell fabricated according to the alternate fabrication method shown in Figures 8A-8C;
Fig. 11A is a planar layout of an anti-fuse transistor not according to the present invention;
Fig. 11B is a cross-sectional view of the anti-fuse transistor of Fig. 11A taken along line A-A;
Fig. 12 is an enlarged planar layout of the anti-fuse transistor of Fig. 11A;
Fig. 13 is a planar layout of a memory array using the anti-fuse transistor of Fig. 11A ;
Fig. 14 is an enlarged planar layout of an anti-fuse transistor;
Fig. 15 is a planar layout of a memory array using the anti-fuse transistor of Figure 14;
Fig. 16A is a planar layout of a two-transistor anti-fuse memory cell ;
Fig. 16B is a cross-sectional view of the two-transistor anti-fuse memory cell of Fig. 16A taken along line B-B;
Fig. 16C is a cross-sectional view of an alternate two-transistor anti-fuse memory cell formed using a thermal oxide process according to the claimed invention;
Fig. 17 is a planar layout of a memory array using the two-transistor anti-fuse memory cell of Figure 16A and 16B;
Fig. 18 is a planar layout of a memory array using the two-transistor anti-fuse memory cell;
Fig. 19-23 are planar layouts of alternate anti-fuse memory cells; and
Fig. 24-27 are planar layouts of alternate two-transistor anti-fuse memory cells.

### DETAILED DESCRIPTION

Generally, the present invention provides a method of forming variable thickness gate oxide anti-fuse transistor device that can be employed in a non-volatile, one-time-programmable (OTP) memory array application. The anti-fuse transistor can be fabricated with standard CMOS technology, and is configured as a standard transistor element having a source diffusion, gate oxide and a polysilicon gate. The variable gate oxide underneath the polysilicon gate comprises a thick gate oxide region and a thin gate oxide region, where the thin gate oxide region acts as a localized breakdown voltage zone. A conductive channel between the polysilicon gate and the channel region can be formed in the localized breakdown voltage zone during a programming operation. In a memory array application, a wordline read current applied to the polysilicon gate can be sensed through a bitline connected to the source diffusion, via the channel of the anti-fuse transistor. More specifically, the present invention provides an effective method for utilizing split channel MOS structures as an anti-fuse cell suitable for OTP memories.

In the following description the term MOS is used to denote any FET or MIS transistor, half-transistor or capacitor structure. In order to simplify the description of the embodiments, references to gate oxides from this point forward should be understood to include dielectric materials, oxide, or a combination of oxide and dielectric materials.

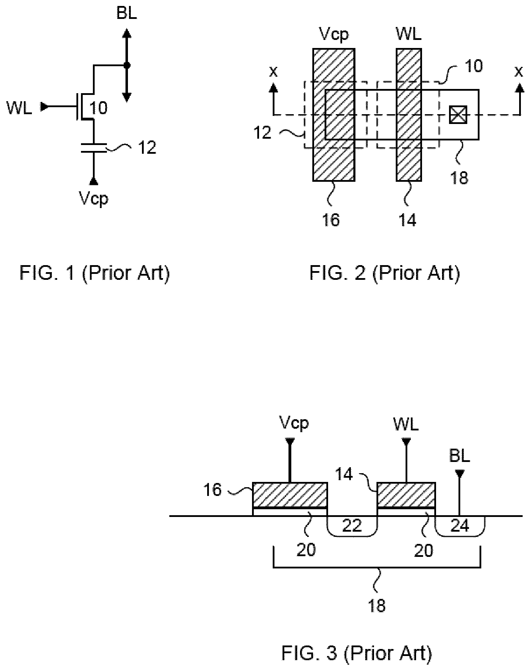

As previously discussed, a DRAM-type memory array using a planar capacitors as an anti-fuse instead of as a storage capacitor is already known, as demonstrated in U.S. Patent No. 6,667,902. Figure 1 is a circuit diagram of such a memory cell, while Figures 2 and 3 show the planar and cross-sectional views respectively, of the known anti-fuse memory cell of Figure 1. The memory cell of Figure 1 includes a pass, or access transistor **10** for coupling a bitline BL to a bottom plate of anti-fuse device **12**. A wordline WL is coupled to the gate of access transistor **10** to turn it on, and a cell plate voltage Vcp is coupled to the top plate of anti-fuse device **12** for programming anti-fuse device **12**.

It can be seen from Figures 2 and 3 that the layout of access transistor **10** and anti-fuse device **12** is very straight-forward and simple. The gate **14** of access transistor **10** and the top plate **16** of anti-fuse device **12** are constructed with the same layer of polysilicon, which extend across active area **18**. In the active area **18** underneath each polysilicon layer, is formed a thin gate oxide **20,** also known as a gate dielectric, for electrically isolating the polysilicon from the active area underneath. On either side of gate **14** are diffusion regions **22** and **24,** where diffusion region **24** is coupled to a bitline. Although not shown, those of skill in the art will understand that standard CMOS processing, such as sidewall spacer formation, lightly doped diffusions (LDD) and diffusion and gate silicidation, can be applied. While the classical single transistor and capacitor cell configuration is widely used, a transistor-only anti-fuse cell is further desirable due to the semiconductor array area savings that can be obtained for high-density applications. Such transistor-only anti-fuses must be reliable while simple to manufacture with a low cost CMOS process.

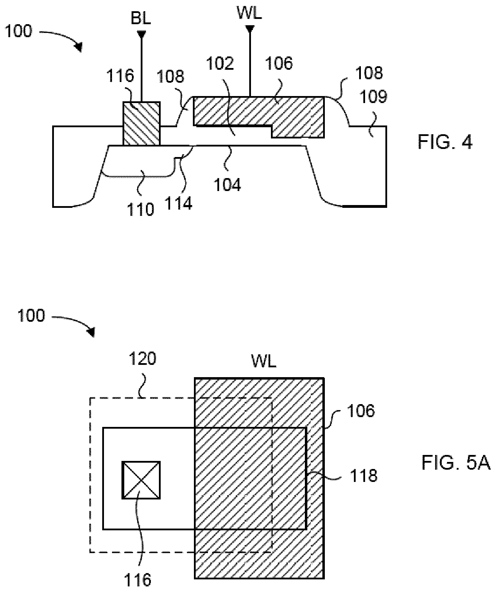

Figure 4 shows a cross-sectional view of an anti-fuse transistor that can be manufactured with any standard CMOS process. In the presently shown example, the anti-fuse transistor is almost identical to a simple thick gate oxide, or input/output MOS transistor with one floating diffusion terminal. The disclosed anti-fuse transistor, also termed a split-channel capacitor or a half-transistor, can be reliably programmed such that the fuse link between the polysilicon gate and the substrate can be predictably localized to a particular region of the device. The cross-section view of Figure 4 is taken along the channel length of the device, which in the presently described embodiment is a p-channel device. Those of skill in the art will understand that the present invention can be implemented as an n-channel device.

Anti-fuse transistor **100** includes a variable thickness gate oxide **102** formed on the substrate channel region **104,** a polysilicon gate **106,** sidewall spacers **108,** a field oxide region **109** a diffusion region **110,** and an LDD region **114** in the diffusion region **110**. A bitline contact **116** is shown to be in electrical contact with diffusion region **110.** The variable thickness gate oxide **102** consists of a thick oxide and a thin gate oxide such that a portion of the channel length is covered by the thick gate oxide and the remaining portion of the channel length is covered by the thin gate oxide. Generally, the thin gate oxide is a region where oxide breakdown can occur. The thick gate oxide edge meeting diffusion region **110** on the other hand, defines an access edge where gate oxide breakdown is prevented and current between the gate **106** and diffusion region **110** is to flow for a programmed anti-fuse transistor. While the distance that the thick oxide portion extends into the channel region depends on the mask grade, the thick oxide portion is preferably formed to be at least as long as the minimum length of a high voltage transistor formed on the same chip.

The diffusion region **110** is connected to a bitline through a bitline contact **116,** or other line for sensing a current from the polysilicon gate **106,** and can be doped to accommodate programming voltages or currents. This diffusion region **110** is formed proximate to the thick oxide portion of the variable thickness gate oxide **102.** To further protect the edge of anti-fuse transistor **100** from high voltage damage, or current leakage, a resistor protection oxide (RPO), also known as a salicide protect oxide, can be introduced during the fabrication process to further space metal particles from the edge of sidewall spacer **108**. This RPO is preferably used during the salicidiation process for preventing only a portion of diffusion region **110** and a portion of polysilicon gate **106** from being salicided.

It is well known that salicided transistors are known to have higher leakage and therefore lower breakdown voltage. Thus having a non-salicided diffusion region **110** will reduce leakage. Diffusion region **110** can be doped for low voltage transistors or high voltage transistors or a combination of the two resulting in same or different diffusion profiles.

A simplified plan view of the anti-fuse transistor **100** is shown in Figure 5a. Bitline contact **116** can be used as a visual reference point to orient the plan view with the corresponding cross-sectional view of Figure 4. The active area **118** is the region of the device where the channel region **104** and diffusion region **110** is formed, which is defined by an OD mask during the fabrication process. The dashed outline **120** defines the areas in which the thick gate oxide is to be formed via an OD2 mask during the fabrication process. More specifically, the area enclosed by the dashed outline **120** designates the regions where thick oxide is to be formed. OD simply refers to an oxide definition mask that is used during the CMOS process for defining the regions on the substrate where the oxide is to be formed, and OD2 refers to a second oxide definition mask different than the first. Details of the CMOS process steps for fabricating anti-fuse transistor **100** will be discussed later. According to an embodiment of the present invention, the thin gate oxide area bounded by edges of the active area **118** and the rightmost edge of the OD2 mask, is minimized. In the presently shown embodiment, this area can be minimized by shifting the rightmost OD2 mask edge towards the parallel edge of active area **118**.

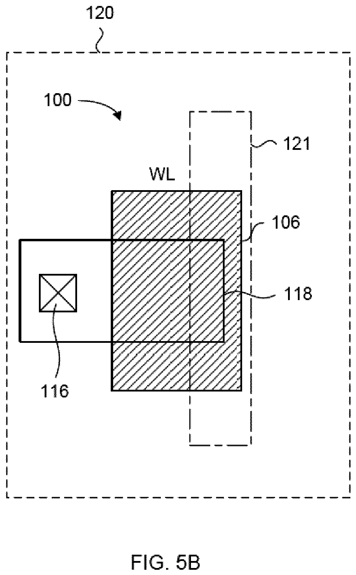

Figure 5b is an alternate illustration of anti-fuse **100** of Figure 5a. In Figure 5a, the OD2 mask **120** is shown as a large area that may extend to cover the entire memory array. As previously discussed, OD2 mask **120** defines the areas in which the thick gate oxide is to be formed. Formed within OD2 mask **120** are openings **121** defining areas where no thick gate oxide is to be formed. Instead, thin gate oxide will be grown in the area defined by openings **121**. Those skilled in the art will understand that in a memory array configuration where a plurality of anti-fuse memory cells **100** are arranged in a row, one rectangular opening can overlap all the memory cells to define the thin gate oxide area for each active area **118.**

Programming of anti-fuse transistor **100** is based on gate oxide breakdown to form a permanent link between the gate and the channel underneath. Gate oxide breakdown conditions (voltage or current and time) depend primarily on i) gate dielectric thickness and composition, ii) defect density, and iii) gate area, gate/diffusion perimeter. The combined thick and thin gate oxide of anti-fuse transistor **100** results in a locally lowered gate breakdown voltage, in particular an oxide breakdown zone, in the thin gate oxide portion of the device. In otherwords, the disclosed structure assures that the oxide breakdown is limited to the thinner gate oxide portion.

Additionally, the anti-fuse transistor embodiments of the present invention take advantage of a typically prohibited CMOS fabrication design rule for gate oxide design layout and formation to enhance gate oxide breakdown performance. All gate oxide processing steps in today's CMOS processes assume and are optimized for uniform gate oxide thickness within the active gate area. By introducing the variable thickness gate oxide devices into the standard CMOS flow, additional defects and electrical field disturbances are created at the boundary between the thick and thin gate oxides. Those defects may include, but are not limited to: oxide thinning, plasma etching of silicon at the boundary, residues from cleaning process and silicon recess due to different thermal oxidation rates between unmasked and partially masked regions. All these effects increase trap and defect density at the thin oxide boundary, leading to increased leakage and locally lowered breakdown voltage. Therefore, a low voltage, compact anti-fuse structure can be created without any process modification.

In a typical CMOS process, the diffusion regions, LDD and channel implantation are different for thin gate oxide transistors and thick gate oxide transistors. According to an embodiment of the present invention, the diffusion regions, LDD and the thin gate oxide channel implantation of the anti-fuse transistors can be either type; the low voltage type corresponding to the thin gate oxide, or the high voltage type corresponding to the thick gate oxide (I/O oxide), or both, provided that the resulting thin gate oxide threshold voltage is not greater in magnitude than the thick gate oxide threshold voltage.

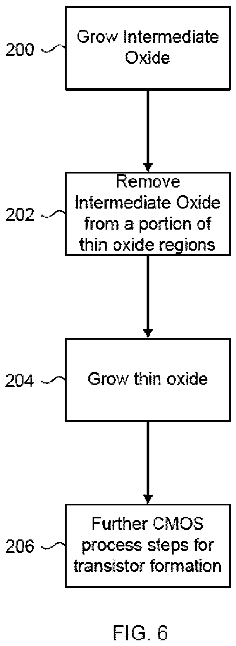

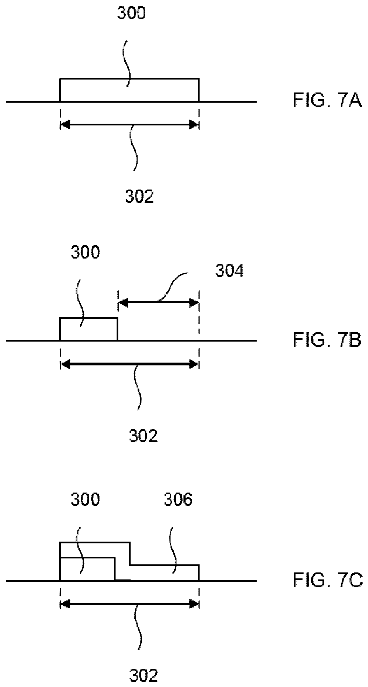

A method of creating a variable thick gate oxide from a standard CMOS process is to utilize a well known two-step oxidation process. A flow chart outlining this process is shown in Figure 6, while Figures 7A-7C show the various stages of the variable thickness gate oxide formation corresponding to specific steps in the process. The method shown in Figures 7A-7C is not according to the claimed invention, but useful for its understanding.

First, an intermediate gate oxide is grown in all active areas determined by the OD mask in step **200.** In Figure 7A, this is shown as the formation of intermediate gate oxide **300** on the substrate, over the channel region **302**. In following step **202,** the intermediate gate oxide **300** is removed from all the designated thin gate oxide areas using an OD2 mask. Figure 7B shows the remaining portion of intermediate gate oxide **300** and the future thin oxide area **304**. In the last gate oxide formation step **204,** a thin oxide is grown again in all active areas as originally defined by the OD mask. In Figure 7C, the thin gate oxide **306** is grown over the intermediate gate oxide **300** and the thin oxide area **304**. In the present embodiment, the thick gate oxide is formed by a combination of removing intermediate gate oxide and growing thin gate oxide over the remaining intermediate gate oxide.

As a result, the formed thick gate oxide area covered by the OD2 mask during step **202** will have a gate oxide thickness being a combination of the intermediate gate oxide **300** and the final thin gate oxide **306**. The same procedure can be extended for more than two oxidation steps, or other equivalent procedures can be used to produce two or more gate oxide thicknesses on the same die, which is determined by at least one thick gate oxide mask OD2.

Typically, the OD2 mask is considered a non-critical masking step, a low resolution mask is used and the design rules require a large margin of the OD2 mask over active gate areas and particularly, do not have provisions for the OD2 mask ending within the active gate area. According to the present invention, the OD2 mask ends within the active gate area creating a split-channel anti-fuse structure that features thicker gate oxide on the drain (i.e. diffusion contact) side and thinner gate oxide on the opposite side (either channel or non-connected source side). In principle, this technology requires that the gate length (polysilicon line width) should be larger then the process minimum and depends on actual OD2 mask tolerances, but otherwise does not require any process or mask grade change. The minimum gate length for the split channel anti-fuse structure can be approximated as a sum of minimum gate length for the thick and thin gate oxide. Those skilled in the art will appreciate that accurate calculations can be made based on mask tolerances, and the gate length can be minimized by tightening OD2 mask tolerances.

Once the variable thickness gate oxide has been formed, additional standard CMOS processing steps can be employed at step **206** to complete the anti-fuse transistor structure as shown in Figure 4. This can include formation of the polysilicon gate, LDD regions, sidewall spacers, RPO, and diffusion regions, and salicidation, for example. According to a preferred embodiment of the presently discussed process, a salicidiation step is included to salicide the polysilicon gate and the floating diffusion region of the anti-fuse transistor. An RPO is formed over the diffusion region before hand to protect it from the salicidation process. As previously mentioned, the salicided floating diffusion region will enhance oxide breakdown in the region.

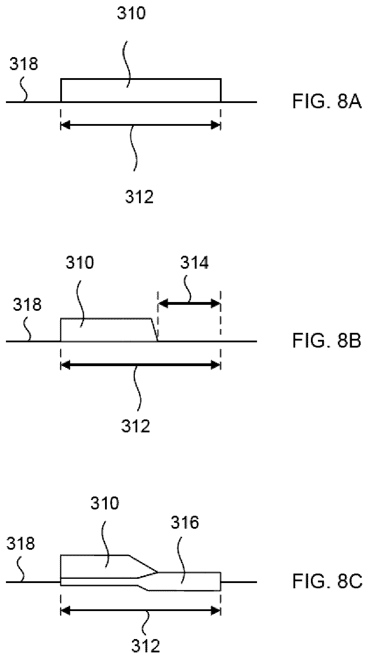

In the process of Figure 6, a thin oxide is grown over the substrate and intermediate gate oxide **300** in step **204,** as shown in Figure 7C. In a method according to the claimed invention for forming a dual thickness gate oxide, the thin oxide is thermally grown from the substrate surface. Thermal oxide growth is known in the art, as demonstrated by previously mentioned U.S. Patent Application Publication No. 20060292755, which uses a thermal oxide growth process to form the gate oxide. This alternate method is described with reference to the flow chart of Figure 6 and Figures 8A-8C that show the various stages of the variable thickness gate oxide formation corresponding to specific steps in the process.

The first step is the same as previously described, where an intermediate gate oxide is grown in all active areas determined by the OD mask in step **200**. In Figure 8A, this is shown as the formation of intermediate gate oxide **310** on the substrate, over the channel region **312.** In following step **202,** the intermediate gate oxide **310** is removed from all the designated thin gate oxide areas using an OD2 mask. Figure 8B shows the remaining portion of intermediate gate oxide **310** and the future thin oxide area **314**. It is noted in Figure 8B that the vertical edge on the right side of intermediate gate oxide **310** is "undercut" during removal of the intermediate gate oxide **310** from thin oxide area **314** during a wet etching process. In the last gate oxide formation step **204,** a thin oxide is thermally grown in the entire channel region **312** of the cell. Thermal oxide growing is a process known in the art, where oxygen atoms combine with silicon atoms of the substrate to form silicon dioxide. The silicon dioxide molecules grow on the surface of the substrate, and each successive layer of silicon dioxide molecules "pushes" previously grown layers upwards. Because this silicon dioxide growth mechanism requires oxygen to reach the silicon substrate surface, its growth rate will be affected by intervening structures which slow the oxygen atoms from reaching the substrate surface.

While anti-fuse transistors can have thin gate oxides formed using this process, any other transistors outside of the memory array can have their gate oxides formed at the same time, meaning that they would have the same gate oxide thickness as the thin oxide formed in step **204**. These transistors can be core transistors, typically used in logic circuits or any other circuits where low voltages and high speed operation are desired.

Figure 8C shows the result of thermally growing oxide in the channel region **312**. In Figure 8C, the thermally grown oxide is shown as thermal oxide **316,** which has "pushed" or displaced the intermediate gate oxide **310** upwards and away from the substrate surface **318.** Because of the presence of intermediate gate oxide **310** previously formed on substrate surface **318** in Figure 8A, the growth rate of thermal oxide **316** under intermediate gate oxide **310** is slower than on the exposed portion of substrate surface **318** of Figure 8B. For this reason, thermal oxide **316** has a thicker portion and a thinner portion. It is noted that the thermal oxide growing process consumes some of the substrate, thereby resulting in a substrate surface having different surface levels. This effect is also referred to as "silicon loss" during a thermal oxidation process. In other words, the substrate surface does not have a uniform surface level in the memory cell area. In the present embodiments, there are portions of thermal oxide **316** formed beneath the surrounding substrate surface **318**.

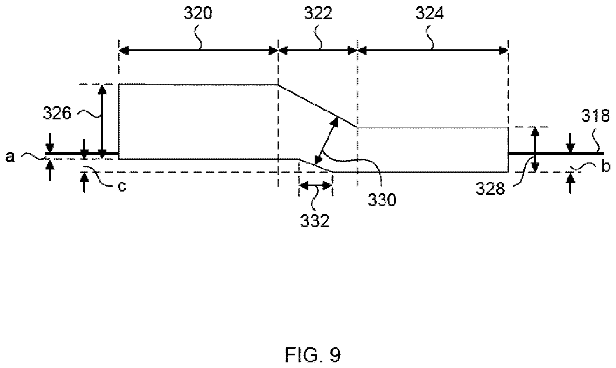

Figure 9 is a magnified illustration of the variable thickness gate oxide shown in Figure 8C. In Figure 9, three different regions of the variable thickness gate oxide are identified. Starting from the left side of the channel region is the thick gate oxide area **320,** followed by an oxide angled area **322,** which is followed by a thin gate oxide area **324**. While oxide angled area **322** is shown to be distinct from thick gate oxide area **320,** oxide angled area **322** can be considered as a part of thick gate oxide area **320**. This is because both areas **320** and **322** are heterogeneous layers having thicknesses consisting of a combination of the intermediate gate oxide **310** and thermal oxide **316**. In contrast, thin gate oxide area **324** is a homogeneous layer of thermal oxide **316**. The thick gate oxide area **320** when combined with an overlying polysilicon gate or other conductive gate, forms an access transistor positioned in series with the anti-fuse device. The anti-fuse device is described in further detail below.

The thick gate oxide area **320** is the combined thicknesses of the thinner portion of the thermal oxide **316** and the intermediate gate oxide **310** shown in Figure 8C. The thin gate oxide area **324** is the thicker portion of the thermal oxide **316** in thin oxide area **314** shown in Figure 8C. The oxide angled area **322** is a transition area between the thick gate oxide area **320** and the thin gate oxide area **324** and may have a thickness different from both the thick gate oxide area **320** and the thin gate oxide area **324**. In particular, the oxide angled area **322** is characterized as being thinner than the thick gate oxide area **320,** but thicker than the thin gate oxide area **324**. Furthermore, the thickness of oxide angled area **322** is variable along the entire oxide angled area **322,** meaning that the thickness is not constant between the top sloping edge of oxide angled area **322** and the bottom edge of oxide angled area **322** that consists of substantially horizontal segments on either side of a sloping segment. During programming, a conductive link can be formed in the angled area **322** or the thin gate oxide area **324**. Therefore, angled area **322** and thin gate oxide area **324** are considered the anti-fuse device of the anti-fuse memory cell. The thick gate oxide of the variable thickness gate oxide is characterized by having the substantially the same thickness **326,** while the thin gate oxide of the variable thickness gate oxide is characterized by having the substantially the same thickness **328**. The oxide angled area **322** is characterized by being angled relative to the thick gate oxide area **320** and the thin gate oxide area **324**, and has a thickness **330** that differs from both thicknesses **326** and **328.**

It is noted that transistors requiring thick gate oxides outside of the memory array can be formed at the same time the thick gate oxide area **320** is formed by thermal oxide growth. Such transistors can include input/output transistors that typically operate at voltages higher than core transistors. Therefore, core transistors and input/output transistors of the memory device can be formed during formation of the anti-fuse memory cell transistors in the memory array. Obvious cost advantages are realized since the same mask set used for forming the memory array anti-fuse memory cells is also used to form the core transistors and the input/output transistors, or vice versa.

The oxide angled area **322** is characterized by having a variable thickness that has a maximum thickness at the virtual interface between thick gate oxide area **320** and oxide angled area **322**, which decreases to have a minimum thickness at the virtual interface between the oxide angled area **322** and the gate oxide area **324**. The channel region **312** is therefore located at different depths relative to the substrate surface **318** due to the different thermal oxide growth rates and the consumption of the substrate surface **318**. As shown in Figure 9, the thick gate oxide area **320** has a bottom side formed at a depth "a" from substrate surface **318**, while thin gate oxide area **324** has a bottom side formed at depth "b" from substrate surface **318**. It is generally known that if a bare silicon surface is oxidized, less than half of the oxide thickness will lie below the original surface, and just more than half will be above it. For example, some empirical measurements have approximated that about 46% of the total oxide thickness lies below the original surface, while the remaining 54% lies above the original surface. Relative to the bottom side of thick gate oxide area **320**, the bottom side of thin gate oxide area **324** extends to a further depth "c" into the substrate. Within the oxide angled area **322**, the channel is angled at region **332**. Therefore, the depth of "b" of the thin gate oxide area **324** is approximately "a" + "c".

One advantage of using a thermal oxide process to fabricate the variable thickness gate oxide shown in Figure 9 is the angled channel resulting from oxide angled area **322**. The distribution of an electrical field resulting from a voltage applied to an overlying polysilicon gate (not shown) is more dense at curves and corners, which enhances oxide breakdown in those areas, when compared to a "flat" channel region.

It is noted that the relative thicknesses of the oxides shown in Figures 8A to 8C are not to scale, as the illustrations are meant to show the general fabrication principles at work. In experimental fabricated anti-fuse memory devices using the presently described method, the combined thinner portion of the thermal oxide **316** and the intermediate gate oxide **310** has been measured to be about 65 angstroms, while the oxide in the thin oxide area **314** has been measured to be about 25 angstroms.

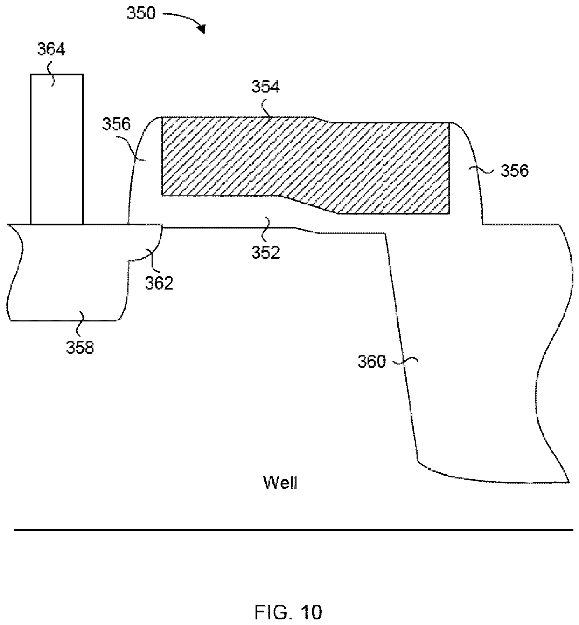

Figure 10 is a cross sectional view of a fully fabricated anti-fuse transistor memory cell fabricated according to the alternate fabrication method shown in Figures 8A-8C. The anti-fuse memory cell **350** has a variable thickness gate oxide **352** similar to the one shown in Figure 9, a gate **354** formed over the variable thickness gate oxide **352,** sidewall spacers **356,** a diffusion region **358** and STI oxide **360**. Diffusion region **358** can have an LDD **362** and a bitline contact **364** connected to a bitline (not shown).

One issue to consider for the above-mentioned anti-fuse transistors is the retention, or reliability or the unprogrammed cells. The described anti-fuse memory cell is programmed by forming a conductive channel between the polysilicon gate and the channel through the thin gate oxide. The resultant programmed state can be detected in a read operation by applying a read voltage to the gate and sensing the voltage of the bitline the anti-fuse is connected to. The typical read voltage is 1.5V to 2.0V depending on process technology. This voltage may exceed the maximum voltage allowed for a DC bias on the gate of the low voltage transistor part of the cell (for example 1.1V for a 1V devices). In otherwords, the read voltage may be sufficiently high to program cells which are to remain in the unprogrammed state. One factor for maximizing reliability of unprogrammed anti-fuse cells is to minimize the area of the thin gate oxide of the variable thickness gate oxide.

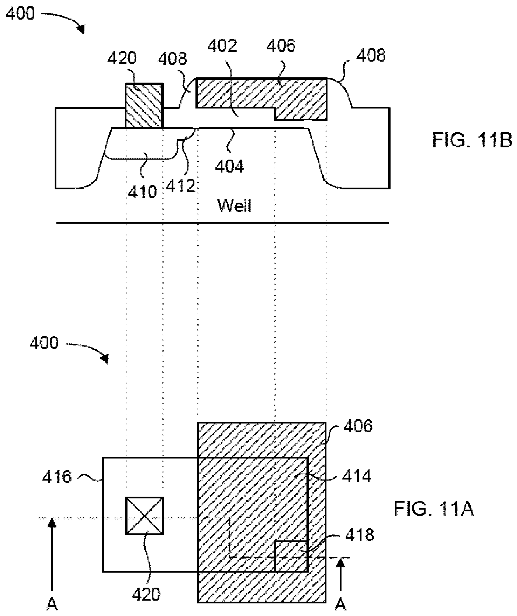

Figure 11A shows a planar view of an anti-fuse transistor having a minimized thin gate oxide area that can be manufactured with any standard CMOS process, not according to the present invention. For example, the fabrication steps outlined in Figure 6 can be used, including the embodiment employing the thermal oxide fabrication steps. Figure 11B shows a cross-sectional view of the anti-fuse transistor of Figure 11A, taken along line A-A. Anti-fuse **400** of Figure 11A is very similar to anti-fuse **100** shown in Figure 5a, except that the area of the thin gate oxide of the variable thickness gate oxide beneath the polysilicon gate is minimized. This is in stark contrast to the anti-fuse cell described by Parris, in which the thin gate oxide portion is maximized such that it surrounds the thick oxide portion in order to elongate the transition line between the thin and the thick oxide portions.

Anti-fuse transistor **400** includes a variable thickness gate oxide **402**, formed on the substrate channel region **404**, a polysilicon gate **406**, sidewall spacers **408**, a diffusion region **410,** and an LDD region **412** in the diffusion region **410**. The variable thickness gate oxide **402** consists of a thick oxide and a thin gate oxide such that a majority area of the channel length is covered by the thick gate oxide and a small minority area of the channel length is covered by the thin gate oxide. As shown in Figure 11A, the thick gate oxide area **414** covers most of the active area **416** under polysilicon gate **406**, except for a small square thin gate oxide area **418**. If anti-fuse **400** is fabricated with the previously described alternate thermal oxide fabrication steps, then thin gate oxide area **418** corresponds to thin gate oxide area **324** of Figure 9. This means that the oxide angled area **322** and thick gate oxide area **320** of Figure 9 are located within thick gate oxide area **414** of Figure 11A. Anti-fuse transistor **400** can be a non-volatile memory cell, and hence will have a bitline contact **420** in electrical contact with diffusion region **410**. The formation of the shape and size of thick gate oxide area **414** and thin gate oxide area **418** is discussed in further detail below.

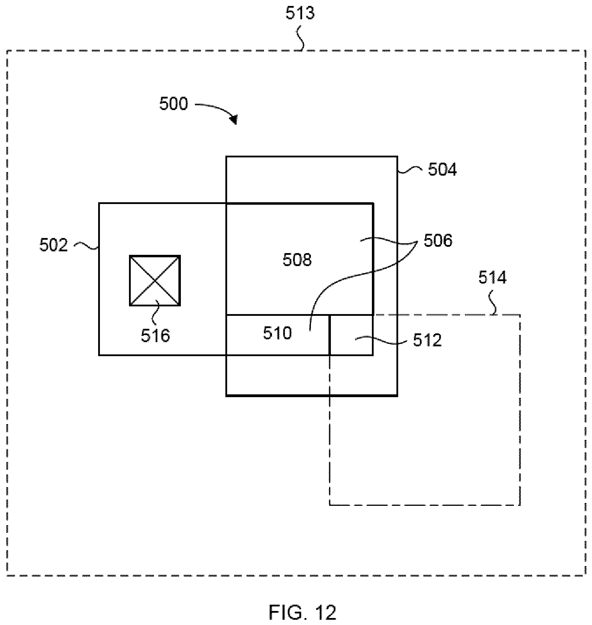

Figure 12 is an enlarged planar view of the anti-fuse transistor of Figure 11A to highlight the planar geometry of the variable thickness gate oxide. Anti-fuse transistor **500** consists of an active area **502** with overlying polysilicon gate **504**. In Figure 12, shading from the polysilicon gate has been removed to clarify the features underneath it. The variable thickness gate oxide is formed between the active area **502** and polysilicon gate **504**, and consists of a thick gate oxide area **506**. According to the present embodiment, thick gate oxide area **506** can be considered as at least two rectangular segments. Those skilled in the art will understand that the delineation of the segments is a visual breakdown of the thick gate oxide shape into constituent rectangular shapes. The first thick gate oxide segment **508** extends from a first end of the channel region, coinciding with the left-most edge of the polysilicon gate **504**, to a second end of the channel region. Segment **508** can be seen as a rectangular shaped area having a width less than the width of the channel region. The second thick gate oxide segment **510** is adjacent to the first segment **508**, and extends from the same first end of the channel region to a predetermined distance of the channel length. The second thick gate oxide segment **510** has a width substantially equal to the difference between the channel width and the width of the first segment **508**.

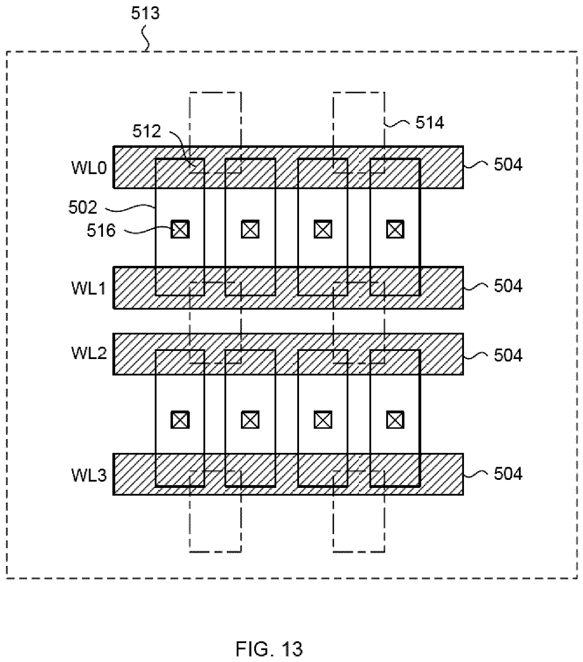

Because the second thick gate oxide segment **510** ends in the channel region, the remaining area is also rectangular in shape as it is bound on two sides by segments **508** and **510,** and on the other two sides by the edges of the active area **502**. This remaining area is the thin gate oxide area **512**. While the OD2 mask **513** defines the areas within which thick oxide is to be formed, the OD2 mask **513** has a rectangular opening **514** in which no thick oxide is to be formed. Thin gate oxide will be grown within the area defined by opening **514**. Expressed in the alternate, the areas outside of the rectangular outline **514** is where thick gate oxide is formed. With reference to the alternate fabrication method using thermal oxide fabrication steps, opening **514** is used to define where thermally grown thin oxide is to be formed. Then segments **508** and **510** are the areas within which thick oxide is a combined thickness of thermally grown oxide and previously formed intermediate oxide. Dashed outline **513** can represent an OD2 mask used during the fabrication process, which is positioned such that a corner of the opening **514** overlaps a corner of the active area **502** underneath the polysilicon gate **504**. The dimensions of opening **514** can be selected to be any size, but has a preferred set of dimensions, as will be discussed with reference to Figure 13. In the single transistor anti-fuse memory cell, a bitline contact **516** is formed for electrical connection to a bitline (not shown).

Figure 13 is a planar layout of a memory array consisting of the anti-fuse memory cell of Figure 12. The memory array has anti-fuse memory cells arranged in rows and columns, where polysilicon gates **504,** formed as continuous polysilicon lines, extend over the active areas **502** of each anti-fuse memory cell in a row. Each polysilicon line is associated with a logical wordline WL0, WL1, WL2 and WL3. In the presently shown embodiment, each active area **502** has two polysilicon gates **504,** thereby forming two anti-fuse transistors that share the same bitline contact **516** and active area **502**. It is noted that all the anti-fuse memory cells of the memory array are formed in a single common well that is formed before any of the anti-fuse memory cell structures are formed.

The openings **514** in the OD2 mask **513** for defining the areas where the thin gate oxide is to be grown is rectangular in shape and sized and positioned such that each of its four corners overlaps with the corner areas of four anti-fuse transistor active areas **502,** thereby defining the thin gate oxide areas **512**. Ideally, the thin gate oxide area has at least one dimension below the minimum feature size of the fabrication process which can be obtained through the overlap between two mask regions. One mask region is the diffusion mask, also called the active area mask, and the second mask region is the rectangular opening **514** in the OD2 mask **513**. Both masks are of a non-critical width, meaning that they are greater than the minimum allowable width. Hence, by positioning the overlap of the two masks, the area of the thin gate oxide areas **512** can have dimensions approximately equal to or below the minimum feature size of the given fabrication process, or technology. Therefore, the dimensions of rectangular shaped opening **514** is selected based on the spacing between horizontally adjacent active areas **502** and the spacing between vertically adjacent active areas **502,** such that the overlap area between the corners of the opening **514** and the diffusion mask for defining the active areas **502** is smaller than or equal to the minimum feature size of the fabrication technology.

The dimensions of opening **514** are selected to minimize the square or rectangular shaped thin gate oxide areas **512**. Those skilled in the art will understand that the selected dimensions will take into account alignment error and fabrication anomalies such as cornering of the 90 degree edges. A high degree of accuracy for the fabrication of the thin gate oxide area **512** can be obtained by using a high grade mask. A high grade mask is provided by using higher quality glass, materials and/or mask printing equipment.

Therefore, the reliability of unprogrammed anti-fuse cells having this minimized feature size thin gate oxide area **512** is greatly improved. The shape of the thin gate oxide area **512** is rectangular, or square, resulting in a minimized area. According to alternate embodiments, instead of having a single rectangular shaped opening **514** overlap with four anti-fuse active areas **502** as shown in Figure 13, multiple smaller openings can be used. For example, an opening can be shaped to overlap only two horizontally adjacent active areas **502.** Or, an opening can be shaped to overlap only two vertically adjacent active areas **502**. Furthermore, individual rectangles larger in size than the desired thin gate oxide area **512** can be used to overlap each active area **502**. While any number of rectangles of any size are contemplated by the previously shown embodiment, the thin gate oxide can be triangular in shape.

The anti-fuse transistors are programmed by rupturing the thin gate oxide, preferably at the thin/thick gate oxide boundary. This is accomplished by applying a high enough voltage differential between the gate and the channel of the cells to be programmed and a substantially lower voltage differential, if any, on all other cells. Therefore, once a permanent conductive link is formed, a current applied to the polysilicon gate will flow through the link and the channel to the diffusion region, which can be sensed by conventional sense amplifier circuits. For example, a VPP high voltage level can be applied to a polysilicon gate **504** while a lower voltage such as ground is applied to its corresponding bitline. Memory cells not to be programmed will have their bitlines biased to a voltage higher than ground, such as VDD for example. Although programming circuitry is not shown, those of skill in the art will understand that such circuits can be coupled to the bitlines, and incorporated into the wordline driver circuits. Reading an anti-fuse memory cell can be done by precharging the bitlines to ground and applying a read voltage, such as VDD, to the polysilicon gates. A programmed anti-fuse having a conductive link will pull its corresponding bitline towards VDD. An unprogrammed anti-fuse with an absence of a conductive link will behave like a switched capacitor, featuring very low leakage current. Therefore, the bitline voltage will not change substantially, if at all. The voltage change can be sensed by a bitline sense amplifier.

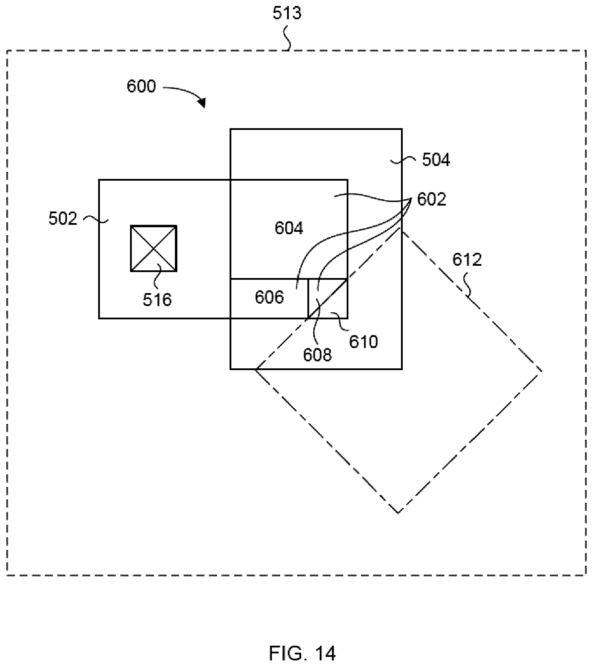

Figure 14 is an enlarged planar layout of another anti-fuse transistor. Anti-fuse transistor **600** is virtually identical to anti-fuse transistor **500,** and therefore has the same active area **502,** polysilicon gate **504,** and bitline contact **516**. Anti-fuse transistor **600** has a differently shaped variable thickness gate oxide. The thick gate oxide area **602** can be seen as being composed of at least two rectangular segments and a triangular segment. A first thick gate oxide segment **604** extends from a first end of the channel region, coinciding with the left-most edge of the polysilicon gate **504,** to a second end of the channel region. Segment **604** can be seen as a rectangular shaped area having a width less than the width of the channel region. The second thick gate oxide segment **606** is adjacent to the first segment **604,** and extends from the same first end of the channel region to a predetermined distance of the channel length. The second thick gate oxide segment **606** has a width substantially equal to the difference between the channel width and the width of the first segment **604**. The third gate oxide segment **608** is triangular in shape and has its 90 degree sides adjacent to the first thick gate oxide segment **604** and the second thick gate oxide segment **606.** Segment **606** can include segment **608,** such that the predetermined distances is set by the diagonal edge of segment **608**. The remaining triangular area having 90 degree sides formed by the edges of the active area **502** is the thin gate oxide area **610**.

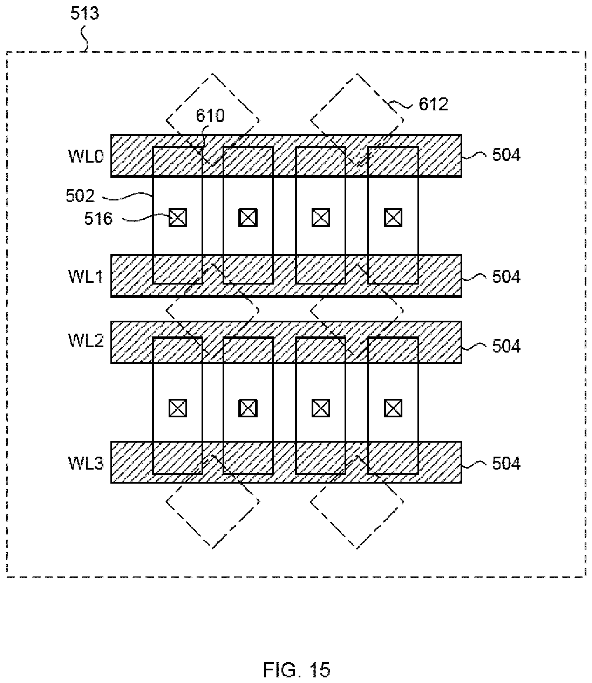

The dashed diamond-shaped area **612** defines openings in the OD2 mask **513** in which the thin gate oxide is to be grown. Expressed in the alternate, the areas outside of the diamond-shaped outline **612** and within OD2 mask **513** is where thick gate oxide is formed. Dashed outline **612** is the opening in the OD2 mask **513** that is used during the fabrication process, and positioned such that an edge of the opening **612** overlaps a corner of the active area **502** underneath the polysilicon gate **504**. With reference to the alternate fabrication method using thermal oxide fabrication steps, opening **612** is used to define where thermally grown thin oxide is to be formed. Then segments **604, 606** and **608** are the areas within which thick oxide is a combined thickness of thermally grown oxide and previously formed intermediate oxide. In the presently shown embodiment, opening **612** is a 45 degree rotated version of opening **514** of Figure 12. The dimensions of opening **612** can be selected to be any size, but has a preferred set of dimensions, as will be discussed with reference to Figure 15.

Figure 15 is a planar layout of a memory array consisting of the anti-fuse memory cell of Figure 14. The memory array has anti-fuse memory cells arranged in rows and columns, where polysilicon gates **504,** formed as continuous polysilicon lines, extend over the active areas **502** of each anti-fuse memory cell in a row. The layout configuration of the polysilicon gates **504** with respect to the active areas **502** is identical to that shown in Figure 13.

The openings **612** in OD2 mask **513** for defining the areas where the thin gate oxide is to be grown is diamond-shaped and sized and positioned such that each of its four edges overlaps with the corner areas of four anti-fuse transistor active areas **502,** thereby defining the thin gate oxide areas **610**. Ideally, each thin gate oxide area **610** is below the minimum feature size of the fabrication process. The overlap is between two mask regions, one being the diffusion mask also called the active area mask, and the second being the OD2 mask **513** having the diamond-shaped openings **612**. It is noted that while the openings **612** are considered diamond-shaped relative to the other features, ie. the polysilicon gates **504** and active areas **502** which are defined with lines at 90 degrees to each other. Therefore, relative to these features, the openings **612** are diamond-shaped and preferably has defining lines 45 degrees relative to the defining lines of the polysilicon gates or the active areas **502**.

Once again, both masks are of a non-critical width, meaning that they are greater than the minimum allowable width. Hence, by positioning the overlap of the two masks, the area of the thin gate oxide areas **610** can have a size that is approximately equal to or below the minimum feature size of the given fabrication process, or technology. Therefore, the dimensions of the diamond-shaped opening **612** is selected based on the spacing between horizontally adjacent active areas **502** and the spacing between vertically adjacent active areas **502,** such that the overlap area between the corners of the openings **612** and the diffusion mask for defining the active areas **502** is smaller than or equal to the minimum feature size of the fabrication technology.

The dimensions of diamond-shaped opening **612** are selected to minimize the triangular shaped thin gate oxide areas **610**. The selected dimensions will take into account alignment error and fabrication anomalies, and a high grade mask can be used to tighten fabrication tolerances.

The previously described embodiments of the non-volatile memory cell are directed to a single anti-fuse transistor memory cell. The variable thickness gate oxide can have a thick gate oxide substantially identical to the gate oxides used for high voltage transistors on the same chip. Similarly, the variable thickness gate oxide can have a thin gate oxide substantially identical to the gate oxides used for low voltage transistors on the same chip. Of course, both the thick and thin gate oxide areas can have thicknesses tailored just for the memory array.

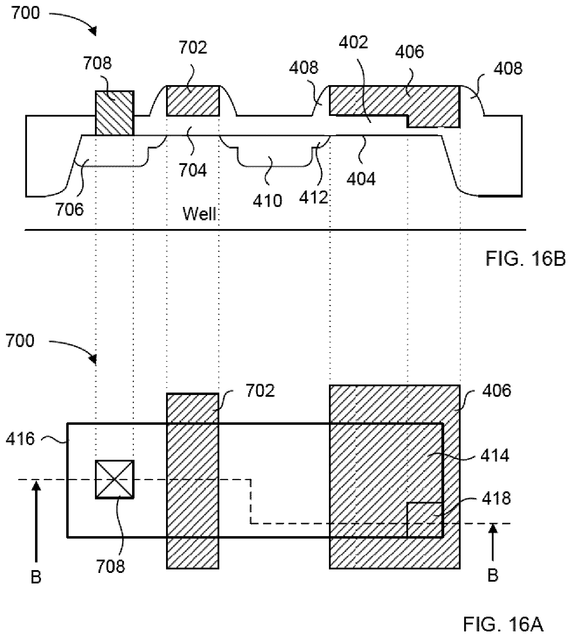

Furthermore, an access transistor can be formed in series with the anti-fuse transistor to provide a two-transistor anti-fuse cell. Figures 16A and 16B are illustrations of a two-transistor anti-fuse memory cell.

Figure 16A shows a planar view of a two-transistor anti-fuse memory cell **700** having a minimized thin gate oxide area that can be manufactured with any standard CMOS process. Figure 16B shows a cross-sectional view of the memory cell **700** of Figure 16A, taken along line B-B, when formed with a process not according to the claimed invention. Two-transistor anti-fuse memory cell **700** consists of an access transistor in series with an anti-fuse transistor. The structure of the anti-fuse transistor can be identical to those shown in Figures 11A to 15. For the present example, it is assumed that the anti-fuse transistor is identical to the one shown in Figure 11B, and hence the same reference numerals indicate the same previously described features. More specifically, the structure of the variable thickness gate oxide is the same as shown in Figure 11B, except that the diffusion region **410** does not have a bitline contact formed on it.

The access transistor has a polysilicon gate **702** overlying a gate oxide **704**. Formed to one side of the gate oxide **704** is the shared diffusion region **410**. Another diffusion region **706** is formed on the other side of the gate oxide **704,** which will have a bitline contact **708** formed on it. Both diffusion regions can have LDD regions adjacent to the vertical edges of gate oxide **704**. Those skilled in the art will understand that the diffusion region **706** can be doped identically to diffusion region **410,** but can be doped differently depending on the desired operating voltages to be used.

As previously described, the variable thickness gate oxide **402** has a thick gate oxide area and a thin gate oxide area. The thickness of gate oxide **704** will be the same as the thickness of the thick gate oxide area of the variable thickness gate oxide **402.** In one embodiment, the access transistor can be fabricated using a high voltage transistor process, or the same process used to form the thick gate oxide area of variable thickness gate oxide **402.** The polysilicon gate **702** can be formed concurrently with polysilicon gate **406**. The anti-fuse transistor can be fabricated using the previously described methods. More specifically, the variable thickness gate oxide **402** can be formed using the previously described thermal oxide process. Furthermore, the access transistor having gate oxide **704** can be formed at the same time that the thick portion of variable thickness gate oxide **402** is formed. Therefore, the thicknesses of gate oxide **704** and the thick portion of variable thickness gate oxide **402** have substantially the same composition and thickness. This is easily done by patterning the access transistor oxide with the same OD2 mask used for forming the variable thickness gate oxide **402**.

The operation of the two-transistor anti-fuse memory cell is similar to that of the previously described single transistor anti-fuse cell. Programming the anti-fuse transistor requires the application of a high voltage to the VCP polysilicon lines while maintaining the bitlines at ground. The access transistor is turned on to couple the shared diffusion region to ground (via a bitline).

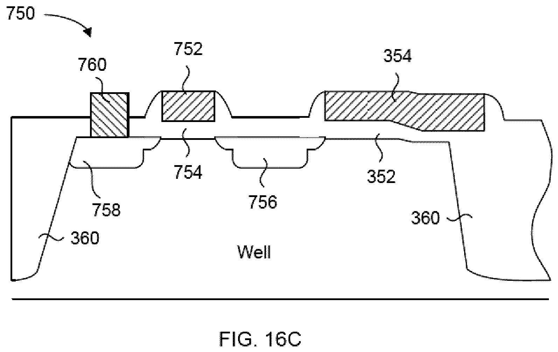

Figure 16C shows a cross-sectional view of a two transistor anti-fuse memory cell, similar to the memory cell **700** of Figure 16A, manufactured according to the method steps of Figures 8A to 8C. The two-transistor anti-fuse memory cell **750** consists of an access transistor in series with an anti-fuse transistor. In this embodiment, the gate oxide of the access transistor is formed at the same time the variable thickness gate oxide is formed. The access transistor has a polysilicon gate **752** overlying a gate oxide **754**. Formed to one side of the gate oxide **754** is the shared diffusion region **756**. Another diffusion region **758** is formed on the other side of the gate oxide **754,** which will have a bitline contact **760** formed on it to make electrical contact with a bitline (not shown). The anti-fuse transistor is identical to the one shown in Figure 10, which includes a gate **354** formed over a variable thickness gate oxide **352.**

As previously discussed and shown in Figure 8C, the variable thickness gate oxide **352** of Figure 16C has a thick gate oxide area (shown as area **320** in Figure 9), which is a combination of intermediate oxide and thermal oxide grown underneath the intermediate oxide. The gate oxide **754** of the access transistor is formed using the same process by which the variable thickness gate oxide **352** is formed. With reference to Figures 8A and 8B, the intermediate oxide **310** is patterned for the desired dimensions of the access transistor of memory cell **700** at the same time the thick gate oxide area of the variable thickness gate oxide is patterned. Therefore, when the thermal oxide is grown to form the variable thickness gate oxide as shown in Figure 8C, the thermal oxide will grow underneath the intermediate oxide of the access transistor. The rate of thermal oxide growth underneath the intermediate oxide of the access transistor will be substantially the same as the thermal oxide growth rate underneath intermediate oxide **310** for the variable thickness gate oxide, and thereby has substantially the same thickness. Because of the silicon loss in the substrate during the thermal oxide growth process, Figure 16C shows how the gate oxide **754** and the variable thickness gate oxide **352** extend below the substrate surface, which is generally delineated by the top surface of diffusion regions **758** and **756.**

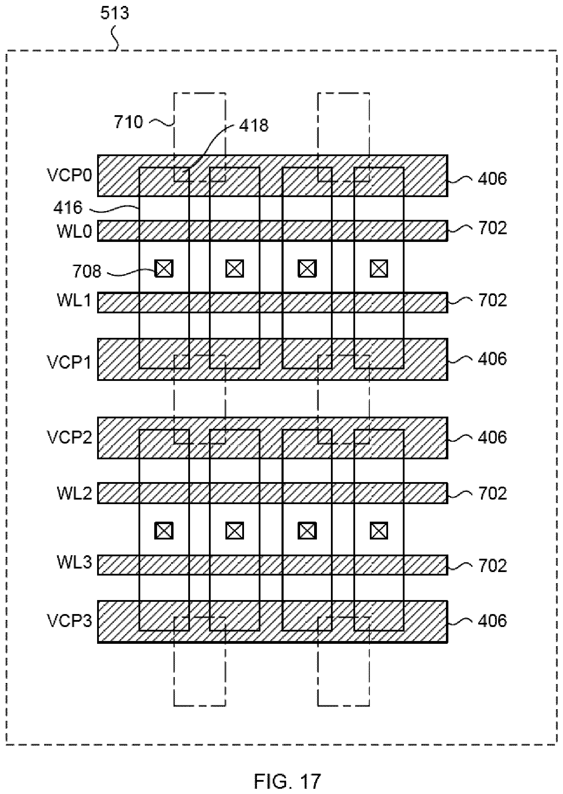

Figure 17 is a planar layout of a memory array consisting of the two-transistor anti-fuse memory cell of Figure 16A and 16B. The memory array has memory cells arranged in rows and columns, where the polysilicon gates **406,** formed as continuous polysilicon lines, extend over the active areas **416** of each anti-fuse memory cell in a row. Each polysilicon line is associated with a logical cell plate VCP0, VCP1, VCP2 and VCP3. The polysilicon gates **702** are formed as continuous polysilicon lines which extend over the active areas **416** of each anti-fuse memory cell in a row. These polysilicon lines are associated with logical wordlines WL0, WL1, WL2 and WL3. In the presently shown embodiment, each active area **416** has two pairs of polysilicon gates **406/702,** thereby forming two anti-fuse transistors that share the same bitline contact **708** and active area **416**. It is noted that all the two transistor anti-fuse memory cells of the memory array are formed in a single common well.

The openings **710** in OD2 mask **513** for defining the areas where the thin gate oxide is to be grown is rectangular in shape and sized and positioned such that each of its four corners overlaps with the corner areas of four anti-fuse transistor active areas **416,** thereby defining the thin gate oxide areas **418.** The same relative mask overlap criteria described for the embodiment Figure 13 applies to the present embodiment. The dimensions of rectangular shaped openings **710** is selected based on the spacing between horizontally adjacent active areas **416** and the spacing between vertically adjacent active areas **416,** such that the overlap area between the corners of the openings **710** and the diffusion mask for defining the active areas **416** is smaller than or equal to the minimum feature size of the fabrication technology.

The embodiment of Figure 17 is configured to having separately controlled cell plates VCP0, VCP1, VCP2 and VCP3, which allows for improved control to prevent unintentional programming of unselected cells. In an alternate embodiment, VCP0, VCP1, VCP2 and VCP3 can be connected to a common node. In such an embodiment, a specific programming sequence is used to prevent unintentional programming of unselected cells. The programming sequence for the alternate embodiment starts with a precharge of all wordlines and bitlines to a high voltage level, followed by driving the common cell plate to a programming voltage VPP. Using the embodiment of Figure 16B for example, this would result in precharging the diffusion region **410** to a high voltage level. The wordline to be programmed is selected by deselecting all of the other wordlines, ie, by driving them to a low voltage level for example. Then, the bitline voltage connected to the selected memory cell is driven to a low voltage level, such as ground for example.

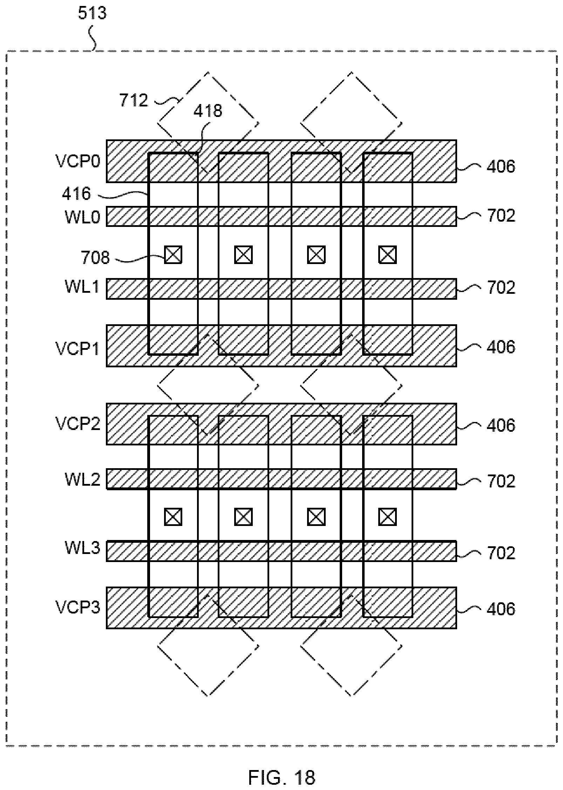

Figure 18 is a planar layout of a memory array consisting of the two-transistor anti-fuse memory cell according to an alternate embodiment. The memory array of Figure 18 is identical to that of Figure 17, except that a diamond-shaped opening **712** withing OD2 mask **513** is used for defining the thin gate oxide areas of the variable thickness gate oxides. The same relative mask overlap criteria described for the embodiment Figure 15 applies to the present embodiment.

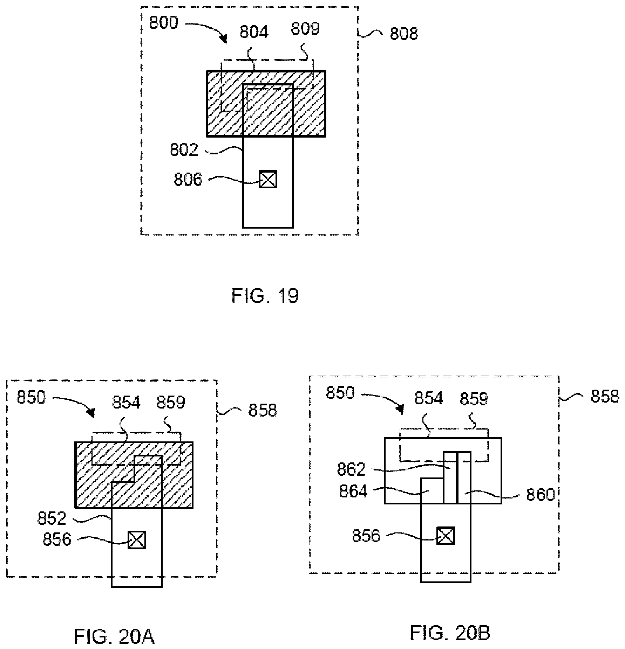

In the previously disclosed embodiments, one of the thick gate oxide segments has a length extending from one end of the channel region to the other end of the channel region. According to an alternate embodiment, the length of this thick gate oxide segment is slightly reduced such that it does not fully extend across the full length of the channel region. Figure 19 is a planar layout of an anti-fuse transistor according to an alternate embodiment. In Figure 19, the anti-fuse transistor **800** includes an active area **802,** a polysilicon gate **804** and a bitline contact **806**. The active area **802** underneath the polysilicon gate **804** is the channel region of anti-fuse transistor **800**. In the present embodiment, OD2 mask **808** defines the area within which thick oxide is to be formed, and includes an "L"-shaped opening **809** overlapping an active area **802,** within which thin gate oxide will be grown. This embodiment is similar to that shown in Figure 12, except that one thick gate oxide segment (ie. **508**) extends to a first predetermined distance between the channel region top edge and a second predetermined distance for the adjacent thick gate oxide segment (ie. 510). Therefore, the thin gate oxide will be grown between the first predetermined distance and the channel region top edge, and the second predetermined distance and the channel region top edge.

The previously described embodiments of the anti-fuse transistor have channel regions of a constant width. According to further embodiments, the channel region can have a variable width across the length of the channel region. Figure 20A is a planar layout of an anti-fuse transistor according to an alternate embodiment. In Figure 20A, the anti-fuse transistor **850** includes an active area **852,** a polysilicon gate **854** and a bitline contact **856.** The active area **852** underneath the polysilicon gate **854** is the channel region of anti-fuse transistor **850**. In the present embodiment, OD2 mask **858** defines the area within which thick oxide is to be formed, and includes a rectangular-shaped opening **859** overlapping the active area **852,** within which thin gate oxide will be grown. The active area underneath the polysilicon gate **854** is "L"-shaped, and the rectangular opening **859** has a bottom edge that ends at a predetermined distance the channel region top edge.

Figure 20B shows the same anti-fuse transistor **850** without shading of the polysilicon gate **854** to illustrate the thick gate oxide segments of the channel region. In the present embodiment, a first thick gate oxide segment **860** extends from the diffusion edge of the channel region to a first predetermined distance defined by the bottom edge of rectangular opening **859**. A second thick gate oxide segment is L-shaped, and includes two sub-segments **862** and **864.** Those skilled in the art will understand that the delineation of the sub-segments is a visual breakdown of the thick gate oxide segment shape into constituent rectangular shapes. Sub-segment **862** extends from the diffusion edge of the channel region to the first predetermined distance, while sub-segment **864** extends from the diffusion edge of the channel region to a second predetermined distance. The second predetermined distance is between the first predetermined distance and the diffusion edge of the channel region. The thin gate oxide region extends from the first predetermined distance of the first thick gate oxide segment **860** and the sub-segment **862** to the channel region top edge.

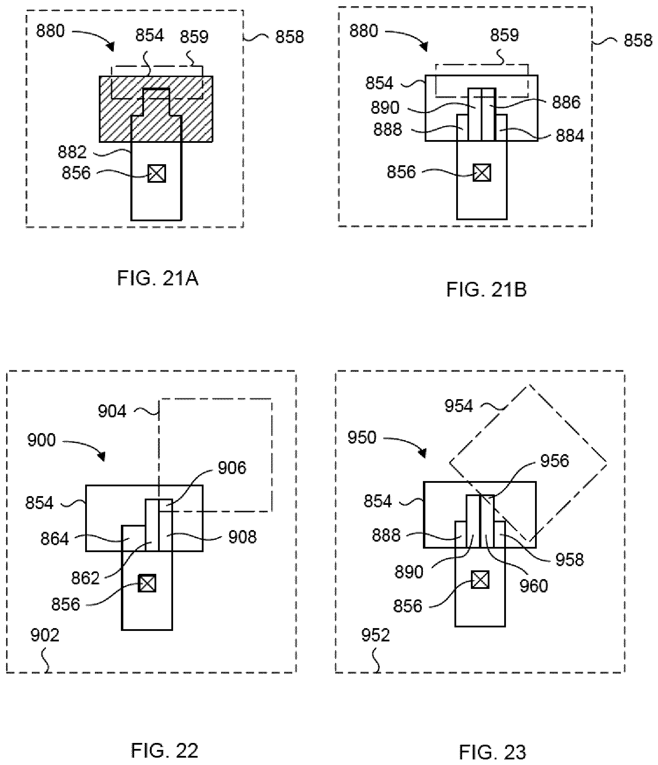

Figure 21A is a planar layout of an anti-fuse transistor according to an alternate embodiment. In Figure 21A, the anti-fuse transistor **880** includes the same features as those in Figure 17. In the present embodiment, the active area underneath the polysilicon gate **854** is "T"-shaped, and the rectangular opening **859** has a bottom edge that ends at a predetermined distance from the channel region top edge. Figure 21B shows the same anti-fuse transistor **880** without shading of the polysilicon gate **854** to illustrate the thick gate oxide segments of the channel region.

In the present embodiment, there is a first thick gate oxide segment and a second gate oxide segment. The first thick gate oxide segment is L-shaped, and includes two sub-segments **884** and **886.** The second thick gate oxide segment is L-shaped, and includes two sub-segments **888** and **890.** Sub-segment **886** extends from the diffusion edge of the channel region to a first predetermined distance, the first predetermined distance corresponding to a bottom edge of the rectangular opening **859.** Sub-segment **884** extends from the diffusion edge of the channel region to a second predetermined distance, where the second predetermined distance is between the first predetermined distance and the diffusion edge of the channel region. Sub-segments **888** and **890** of the second thick gate oxide segment are identically configured to sub-segments **884** and **886** respectively. The thin gate oxide region extends from the first predetermined distance of sub-segments **886** and **890** to the channel region top edge.

In the previously described embodiments of Figures 20A and 21A, the thin gate oxide area extends from a bottom edge of the rectangular opening **859** to the channel region top edge. Because the channel region has a variable width, in which a portion proximate to the diffusion edge is larger than the portion proximate to the channel region top edge, the overall the thin gate oxide area can be smaller than the anti-fuse embodiment shown in Figure 5a. According to further embodiments, the thin gate oxide of the anti-fuse transistor embodiments of Figures 20A and 21A are further minimized by applying an OD2 mask having the rectangular or diamond-shaped openings shown in Figures 12 and 14.

Figure 22 is a planar layout of an anti-fuse transistor according to an alternate embodiment. Anti-fuse transistor **900** is similar to anti-fuse transistor **850** of Figure 20B, except that OD2 mask **902** includes rectangular opening **904** shaped and positioned for delineating the thin gate oxide area **906**. In the presently shown embodiment, the thick gate oxide comprises a first thick gate oxide segment **908** and a second thick gate oxide segment having sub-segments **862** and **864.** Sub-segments **862** and **864** are the same as in the embodiment of Figure 20B. However, due to the overlapping corners of rectangular opening **904** and the channel region, the first thick gate oxide segment **908** only extends from the diffusion edge to a predetermined distance of the channel length. Hence, the thick gate oxide segment **908** is shorter in length than sub-segment **862** . Accordingly, anti-fuse transistor **900** has a smaller thin gate oxide area than the embodiment of Figure 20A. The application of the OD2 mask **902** with rectangular openings **904** can be applied to anti-fuse transistor **880** of Figure 21B with the same result.

A further reduction in the thin gate oxide area of the anti-fuse transistors **850** and **880** is obtained by applying diamond-shaped openings in the OD2 mask, as illustrated earlier in Figure 14. Figure 23 is a planar layout of an anti-fuse transistor according to an alternate embodiment. Anti-fuse transistor **950** is similar to anti-fuse transistor **880** of Figure 21B, except that OD2 mask **952** includes rectangular opening **954** shaped and positioned for delineating the thin gate oxide area **956**. In the presently shown embodiment, the thick gate oxide comprises first and second thick gate oxide segments. The first thick gate oxide segment includes sub-segments **888** and **890,** which are the same as in the embodiment of Figure 21B. The second thick gate oxide segment includes sub-segments **958** and **960.**

Due to the overlap of diamond-shaped opening **954** and the channel region, the second thick gate oxide sub-segment **960** only extends from the diffusion edge to a predetermined distance of the channel length, the predetermined distance being defined by the diagonal edge of the diamond-shaped opening **954**. Accordingly, anti-fuse transistor **950** can have a smaller thin gate oxide area than the embodiment of Figure 22. The application of the OD2 mask **952** with diamond-shaped opening **954** can be applied to anti-fuse transistor **850** of Figure 20B with the same result. It is noted that the dimensions of sub-segments **958** and **960** are selected such that the diagonal edge of opening **954** does not overlap with the channel region covered by sub-segment **958**.

While rectangular and diamond-shaped openings in the OD2 mask are disclosed, other opening shapes can be used with equal effectiveness. For example, the openings in the OD2 mask can be hexagon-shaped, octagon-shaped, or even substantially circular after OPC is added. Furthermore a rectangular shaped opening can be rotated by any angle relative to the polysilicon gate.

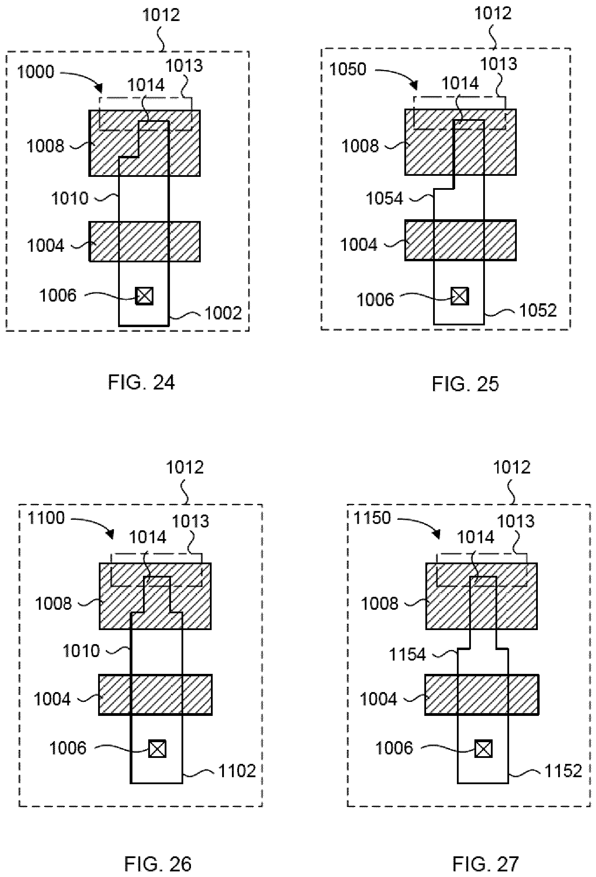

The previously described embodiments of Figures 19-23 are directed to single transistor anti-fuse memory cells. The embodiments of Figures 19-23 are applicable to two-transistor anti-fuse cells, in which an access transistor is formed in series with the anti-fuse transistor. Figures 24-27 illustrate various embodiments of a two-transistor anti-fuse memory cell having minimized thin gate oxide areas.

Figure 24 is a planar layout of a two-transistor anti-fuse transistor.

According to further embodiments, an access transistor can be formed in series with the anti-fuse transistor to provide a two-transistor anti-fuse cell. Figures 16A and 16B are illustrations of a two-transistor anti-fuse memory cell where the channel region has a variable width. Two-transistor anti-fuse memory cell **1000** is similar to the two-transistor cell 700 of Figure 16A. The access transistor includes active area **1002,** a polysilicon gate **1004** and a bitline contact **1006**. The anti-fuse transistor includes active area **1002,** a polysilicon gate **1008.** A common source/drain diffusion region **1010** is shared between the access transistor and the anti-fuse transistor. Underneath the polysilicon gate **1008** and covering the channel region is the variable thickness gate oxide having a thick gate oxide area and a thin gate oxide area. OD2 mask **1012** illustrates the areas in which a thick gate oxide is to be formed, and includes a rectangular-shaped opening **1013** overlapping the active area **852**, within which thin gate oxide will be grown. Thin gate oxide area **1014** covers the channel region between the bottom edge of the rectangular opening **1013** and the channel region top edge.

In Figure 24 the channel region of the anti-fuse transistor has a variable width. In the embodiment of Figure 25, the channel region of the anti-fuse transistor has a constant width, but is smaller in width than the remainder of the active area and the channel of the access transistor. More specifically, two-transistor anti-fuse memory cell **1050** is similar to memory cell **1000,** except that active area **1052** is shaped such that the common source/drain diffusion region **1054** now has a variable width, leaving the channel region of the anti-fuse transistor constant, but smaller in width than the channel region of the access transistor.

Figure 26 is yet another alternate embodiment of the two-transistor anti-fuse memory cell. Two-transistor anti-fuse memory cell **1100** is similar to two-transistor anti-fuse memory cell **1000** of Figure 24, except that the active area **1102** is shaped such that the anti-fuse transistor has a "T"-shaped channel region instead of the "L"-shaped channel region. Figure 27 is similar to the embodiment of Figure 26, except that two-transistor anti-fuse memory cell **1150** has an active area **1152** shaped such that the anti-fuse transistor has a channel region of a constant width. The common source/drain diffusion region **1154** is "T"-shaped such that it has a portion of narrower width.

The two-transistor anti-fuse memory cell embodiments of Figures 24-27 can use OD2 masks having rectangular or diamond-shaped openings positioned to minimize the thin gate oxide areas of the anti-fuse transistors. The anti-fuse memory cell embodiments of Figures 19 to 27 can be fabricated with the alternate fabrication process where thermal oxide is grown to form the thick and thin portions of the variable thickness gate oxide.

As shown in the presently described embodiments, a single transistor anti-fuse memory cell and a two-transistor anti-fuse memory cell having high reliability can be manufactured using standard CMOS processes. The masks for defining the active areas and the OD2 masks can be non-critical in size but the positioned overlap between specific areas can result in a thin oxide area with a size less than the minimum feature size for the process technology.

More specifically, the standard CMOS process will require a set of masks for defining the various features of the presently described anti-fuse memory cell embodiments. Each mask will have different quality grades, depending on the features that are to be defined. Generally, higher grade masks are used for defining smaller sized features. Following is an example grading of masks used in the standard CMOS process, where higher numbers designate higher grade masks.
1. N-well, P-well, Vtp, Vtn, thick gate oxide (OD2) masks
2. source/drain implant mask
3. contact via mask
4. metal 2 layer mask
5. diffusion, thin oxide, contact and metal 1 layer masks
6. polysilicon mask

The difference between a high grade mask, such as grade level 6, over a low grade mask, such as grade level 1, will be the better glass, materials or use of better printing equipment involved to make it. Different mask grades are used because certain features do not require high accuracy, while others do. As can be appreciated, the effort and cost for producing a high grade mask is substantially more than required for a low grade mask. For example, the lowest grade mask can range between $3k-$5k, while the highest grade mask can range between $100k-$300k.

It should be noted that design rules for certain features are set up to ensure that a specific area for that feature defined by a mask covers not only the specific area, but has some overlap onto adjacent features. In effect, the adjacent features truly control where the implantation occurs. For example, the OD2 shape will fully cover the IO transistor area, which is defined by diffusion. Hence, it does not matter where the actual mask shape ends. This is one primary reason why the OD2 mask is a low grade, and consequently, a low cost mask, as there is an allowed margin of error. Furthermore, some aligner machines are capable of achieving 0.06 micron tolerance, but are only used at 0.1 micron as it is deemed sufficient for ion implant masks. For fabricating the anti-fuse transistors and memory arrays shown in Figures 4 to 18, the mask shape ends are important for defining the thin gate oxide area. The current grade OD2 mask used for typical CMOS processes can be used for defining the thin gate oxide areas of the described anti-fuse memory cells. However, the margin of error must be taken into account, thereby resulting in a memory cell having a particular minimum size.

With the methods described above, the anti-fuse memory cells of Figures 4-18 are fabricated using an OD2 mask having a grade corresponding to the mask grade used for source/drain implants (grade level 2) of the same process. The OD2 mask grade is preferably equivalent to the mask grade used for diffusion implants (grade level 5) of the same process to achieve smaller sized memory cells having high reliability. Therefore, higher density memory arrays, improved yield, improved performance and high reliability are obtained by using a high grade OD2 mask. The accuracy is further improved by ensuring that alignment of the mask is done at the highest possible accuracy level. High alignment accuracy is obtained by using superior lithography equipment, lithography methods and/or different light wavelengths and different mask types, any combination thereof being possible.

The use of a higher grade OD2 mask with optional high accuracy alignment presents advantages for the presently disclosed anti-fuse cell embodiments. More specifically, the more accurately formed mask shape ends using a high grade OD2 mask are advantageously used to minimize specific features such as the thin oxide areas. Since the anti-fuse transistors **500** and **600** should have a minimally sized thin gate oxide area **(512** and **610),** the use of a high grade OD2 mask allows the thin gate oxide areas to be minimized to improve reliability over the same anti-fuse cell manufactured with a standard low grade OD2 mask.

For the embodiment of Figure 5A, more accurate overlap of the OD2 shape end/edge underneath the polysilicon gate **106** allows for a minimized thin oxide area under the polysilicon gate. In particular, the thin oxide area will be rectangular in shape, having two opposite sides defined by the width of the active area underneath the polysilicon gate, and another two opposite sides defined by the OD2 mask shape end underneath the polysilicon gate and an edge of the polysilicon gate. The addition of high precision alignment will further minimize the thin oxide area.

For example, an improvement in alignment from +/- 0.1 microns to +/- 0.06 microns for a 0.20 micron thin oxide area dimension, will allow for a 0.04 micron smaller thin oxide dimension, thereby reducing the dimension to 0.16 microns. This alone will improve the yield and reliability of the anti-fuse memory cell since both yield and reliability depend directly upon the total thin gate oxide area. Yield and reliability improvements are seen even when alignment is improved to +/- 0.08 microns for 90nm and 65nm processes. The high grade OD2 mask can be used in the process described in Figure 6 for fabricating the thin and thick gate oxide areas of the anti-fuse transistor.

The drawings of the transistor devices presented in the figures are used to illustrate features of the transistor devices, and are intended to be drawn to scale. Actual fabricated transistor devices including the described features will have dimensions resulting from design choices or the application of design rules imposed by specific fabrication processes.

The presently described embodiments of the invention describe anti-fuse transistors having thin and thick gate oxides. Those skilled in the art will understand that advanced semiconductor manufacturing technologies can use different dielectric materials for forming the thin gate oxide areas, in addition to or instead of oxide. Those skilled in the art will understand that the mask for depositing or growing the dielectric can have shaped openings positioned to overlap the active area, in the same manner as previously described for the OD2 mask used to define the thin gate oxide area of the anti-fuse transistor.

Those skilled in the art will understand that the OD2 mask with openings to define thin gate oxide areas can be an assembly of smaller unit sub-mask shapes tiled together in a repeating pattern, each having a full opening defined therein, or a portion of an opening defined therein such that the mating of adjacent tiles will result in an enclosed opening.

The above-described embodiments of the present invention are intended to be examples only. Alterations, modifications and variations may be effected to the particular embodiments by those of skill in the art without departing from the scope of the invention, which is defined solely by the claims appended hereto.

## Claims

1. A method of forming an anti-fuse transistor with a variable thickness gate oxide comprising the steps of:
growing a first oxide (310) in a channel region (312) of the anti-fuse transistor; removing, by a wet etching process, the first oxide (310) from a thin gate oxide area (314, 324) of the channel region (312) with a vertical edge of the first oxide (310) facing the thin gate oxide area (314, 324) undercut,
thermally growing a second oxide (316) in the thin gate oxide area (314, 324) adjacent to the undercut vertical edge, in an angled oxide area (322) of the channel region (312) between the thin gate oxide area (314, 324) and a thick gate oxide area (320), and in the thick gate oxide area (320) of the channel region (312) under the first oxide (310), including forming the angled oxide area (322) having a thickness different from the combination of the first oxide (310) and the second oxide (316) in the thick gate oxide area (320), and different from the second oxide (316) in the thin gate oxide area (314, 324), and a combination of the first oxide (310) and the second oxide (316) in the thick gate oxide area (320) has a thickness greater than the second oxide (316) in the thin gate oxide area (314, 324); and
forming a diffusion region (358) adjacent the thick gate oxide area (320) for receiving current from the channel region (312).

2. The method of claim 1, wherein thermally growing includes growing the second oxide (316) in the thin gate oxide area (314, 324) at a first rate and growing the second oxide (316) in the thick gate oxide area (320) at a second rate less than the first rate.

3. The method of claim 2, wherein growing the second oxide (316) in the thin gate oxide area (314, 324) at a first rate includes consuming a substrate surface (318) of the thin gate oxide area (314, 324) to a first depth, and growing the second oxide (316) in the thick gate oxide area (320) includes consuming a substrate surface (318) of the thick gate oxide area (320) to a second depth less than the first depth.

4. The method of claim 3, further including forming a common gate (354) over the first oxide (310) the second oxide (316), and the angled oxide area (322).

5. The method of claim 4, further including forming a bitline contact (364) in electrical contact with the diffusion region (358) for sensing a current from the common gate (354) when a conductive link is formed between the channel region (312) and the common gate (354).

## Patentansprüche

1. Verfahren zum Herstellen eines Antifuse-Transistors mit einer variablen Gateoxid-Dicke, umfassend die Schritte:
Aufwachsen eines ersten Oxids (310) in einem Kanalbereich (312) des Antifuse-Transistors;
Entfernen, durch einen Nassätzprozess, des ersten Oxids (310) von einer Fläche mit dünnem Gateoxid (314, 324) des Kanalbereichs (312), wobei eine vertikale Kante des ersten Oxids (310), die der Fläche mit dünnem Gateoxid (314, 324) zugewandt ist, unterhöhlt ist,
thermisches Aufwachsen eines zweiten Oxids (316) in der Fläche mit dünnem Gateoxid (314, 324), die benachbart zur unterhöhlten vertikalen Kante liegt, in einer geneigten Oxidfläche (322) des Kanalbereichs (312) zwischen der Fläche mit dünnem Gateoxid (314, 324) und einer Fläche mit dickem Gateoxid (320) und in der Fläche mit dickem Gateoxid (320) des Kanalbereichs (312) unterhalb des ersten Oxids (310), einschließlich des Herstellens der geneigten Oxidfläche (322) mit einer Dicke, die sich von der Kombination aus dem ersten Oxid (310) und dem zweiten Oxid (316) in der Fläche mit dickem Gateoxid (320) unterscheidet und sich von dem zweiten Oxid (316) in der Fläche mit dünnem Gateoxid (314, 324) unterscheidet, und die Kombination aus dem ersten Oxid (310) und dem zweiten Oxid (316) in der Fläche mit dickem Gateoxid (320) eine größere Dicke als das zweite Oxid (316) in der Fläche mit dünnem Gateoxid (314, 324) aufweist; und
Herstellen eines Diffusionsbereichs (358) benachbart zu der Fläche mit dickem Gateoxid (320) zum Aufnehmen von Strom aus dem Kanalbereich (312).

2. Verfahren nach Anspruch 1, wobei das thermische Aufwachsen das Aufwachsen des zweiten Oxids (316) in der Fläche mit dünnem Gateoxid (314, 324) mit einer ersten Geschwindigkeit und das Aufwachsen des zweiten Oxids (316) in der Fläche mit dickem Gateoxid (320) mit einer zweiten Geschwindigkeit, die geringer als die erste Geschwindigkeit ist, enthält.

3. Verfahren nach Anspruch 2, wobei das Aufwachsen des zweiten Oxids (316) in der Fläche mit dünnem Gateoxid (314, 324) mit einer ersten Geschwindigkeit das Abtragen einer Substratoberfläche (318) der Fläche mit dünnem Gateoxid (314, 324) bis zu einer ersten Tiefe enthält und das Aufwachsen des zweiten Oxids (316) in der Fläche mit dickem Gateoxid (320) das Abtragen einer Substratoberfläche (318) der Fläche mit dickem Gateoxid (320) bis zu einer zweiten Tiefe, die geringer als die erste Tiefe ist, enthält.

4. Verfahren nach Anspruch 3, wobei ferner das Herstellen eines gemeinsamen Gates (354) über dem ersten Oxid (310), dem zweiten Oxid (316) und der geneigten Oxidfläche (322) enthalten ist.

5. Verfahren nach Anspruch 4, wobei ferner das Herstellen eines Bitleitungskontakts (364), der in elektrischem Kontakt mit dem Diffusionsbereich (358) steht, enthalten ist, um einen Strom vom gemeinsamen Gate (354) zu erfassen, wenn eine leitende Verbindung zwischen dem Kanalbereich (312) und dem gemeinsamen Gate (354) hergestellt wird.

## Revendications

1. Procédé de fabrication d'un transistor anti-fusible avec un oxyde de grille d'épaisseur variable, comprenant les étapes suivantes :
la croissance d'un premier oxyde (310) dans une région de canal (312) du transistor anti-fusible ;
l'élimination, par un processus de gravure chimique humide, du premier oxyde (310) d'une zone d'oxyde de grille mince (314, 324) de la région de canal (312), premier oxyde (310) dont un bord vertical est orienté vers la zone d'oxyde de grille mince (314, 324) en contre-dépouille,
la croissance thermique d'un deuxième oxyde (316) dans la zone d'oxyde de grille mince (314, 324), adjacente au bord vertical en contre-dépouille dans une zone d'oxyde formant un angle (322) de la région de canal (312), située entre la zone d'oxyde de grille mince (314, 324) et une zone d'oxyde de grille épaisse (320), ainsi que dans la zone d'oxyde de grille épaisse (320) de la région de canal (312) sous le premier oxyde (310) incluant la formation de la zone d'oxyde formant un angle (322) ayant une épaisseur différente de la combinaison du premier oxyde (310) et du deuxième oxyde (320) dans la zone d'oxyde de grille épaisse (320), et différente du deuxième oxyde (316) dans la zone d'oxyde de grille mince (314, 324), et une combinaison du premier oxyde (310) et du deuxième oxyde (316) dans la zone d'oxyde de grille épaisse (320) présente une épaisseur supérieure à celle du deuxième oxyde (316) dans la zone d'oxyde de grille mince (314, 324) ; et
la formation d'une région de diffusion (358) adjacente à la zone d'oxyde de grille épaisse (320) pour recevoir le courant provenant de la région de canal (312).

2. Procédé selon la revendication 1, dans lequel la croissance thermique comprend la croissance du deuxième oxyde (316) dans la zone d'oxyde de grille mince (314, 324) à une première vitesse et la croissance du deuxième oxyde (316) dans la zone d'oxyde de grille épaisse (320) à une deuxième vitesse inférieure à la première vitesse.

3. Procédé selon la revendication 2, dans lequel la croissance du deuxième oxyde (316) dans la zone d'oxyde de grille mince (314, 324) à une première vitesse comprend la consommation d'une surface de substrat (318) de la zone d'oxyde de grille mince (314, 324) jusqu'à une première profondeur et la croissance du deuxième oxyde (316) dans la zone d'oxyde de grille épaisse (320) comprend la consommation d'une surface de substrat (318) de la zone d'oxyde de grille épaisse (320) jusqu'à une deuxième profondeur inférieure à la première profondeur.

4. Procédé selon la revendication 3, comprenant en outre la formation d'une grille commune (354) sur le premier oxyde (310), la deuxième couche d'oxyde (316) et la zone d'oxyde formant un angle (322).

5. Procédé selon la revendication 4, comprenant en outre la formation d'un contact de ligne de bits (364) en contact électrique avec la région de diffusion (358) pour détecter un courant provenant de la grille commune (354) lorsqu'une liaison conductrice est formée entre la région de canal (312) et la grille commune (354).
